# EUROPEAN PATENT SPECIFICATION

(11) **EP 3 956 977 B1**
(45) Date of publication and mention of the grant of the patent: **18.11.2026**
(21) Application number: 19756007.1
(22) Date of filing: 26.07.2019
(51) Int. Cl.: H02S 20/00, H10F 19/00, H10F 19/80, H02S 20/24, H02S 30/00

(54) **SOLAR PANEL**
SOLARPANEEL
PANNEAU SOLAIRE

(30) Priority: 15.04.2019 NL 2022944
(43) Date of publication of application: 23.02.2022
(73) Proprietor: Solarge Holding B.V., 5641 TD Eindhoven (NL)
(72) Inventor: SELTEN, Wilhelmus Nicolaas Maria, 5641 TD Eindhoven (NL); ZWEGERS, Stefan Henricus Maria, 5641 TD Eindhoven (NL); VAN DEN DONKER, Menno Nicolaas, 5641 TD Eindhoven (NL); VAN DEN HEUVEL, Huibert Johan, 5641 TD Eindhoven (NL); VAN DE VEN, Marcus Leonardus Gerardus Maria, 5641 TD Eindhoven (NL)
(74) Representative: V.O.
(86) International application number: PCT/NL2019/050501
(87) International publication number: WO 2020/214023

(56) References cited:
- WO-A1-2017/172056
- US-A1- 2007 074 755
- US-A1- 2009 320 898
- US-A1- 2012 090 659
- US-A1- 2017 338 767
- US-A1- 2018 316 302

## Description

### TECHNICAL FIELD AND BACKGROUND

The present disclosure relates to solar panels, assemblies thereof, and to methods for the manufacturing thereof.

Known photovoltaic panels, also known as solar panels, typically comprise, in order from the front light-receiving side to the back: a protective front layer, a layer comprising interconnected photovoltaic elements and a back layer. Glass is widely used for the protective front layer as being suitable to, in use, protect the photovoltaic panels from externally induced damage, e.g. due to weather conditions such as rain and hail, while being sufficiently transparent to allow incident light to reach the photovoltaic cells. The back layer may also be a glass sheet, or a metal sheet or any other panel such as polymer-based panels suitable to its purpose of providing electrical insulation of the photovoltaic elements and providing a weather tight closure to the back of the photovoltaic elements.

Typically solar panels are mounted under a slanting angle. An advantage thereof is that incoming water, e.g. rain may run off the surface of the panel. Solar panels are typically mounted under an angle in excess of 10° with respect to level. By placing solar panels under an angle sufficient to drain off incoming water, contamination on the panel surface, e.g. by growth of biological material such as algae or moss may be reduced. Further panels mounted under a sufficient angle may be passive cleaned, e.g. due to incident rain washing away contamination, e.g. sand, dust, and/or soot. In order to achieve such orientation, panels including a mounting frame are commonly mounted onto a dedicated carrier structure. For example, for flat or very shallow rooftops such mounting structure may include a metallic frame that is secured to the roof. Besides assembly time and costs the weight of such dedicated carrier structures is disadvantageous. Accordingly, there exists a need to provide solar panels that can be mounted under an angle to a support structure with one or more of a reduced assembly effort, reduced material cost, and reduced weight, e.g. reduced load to the support structure.

The photovoltaic panel according the present disclosure mitigates one or more of the above or other problems.

### SUMMARY

Aspects of the present disclosure relate to a pre-formed solar panel. The pre-formed solar panel is to be mounted onto a support plane of a carrier structure. The pre-formed solar panel has in a direction from a first end to a second opposing end at least a first planar section, a plastically deformed section and a second planar section. At least one of the planar sections is, at least partially, provided with a photo active layer, e.g. a photovoltaic layer. The plastically deformed section maintains the first and the second planar section relative to each other at a pre-set enclosed angle. Preferably, the enclosed angle between first and the second planar sections is in a range between 30° and 170°. The support plane may be understood to be a surface of any suitable carrier, including, but not limited to a roof (flat roof, slanted roof); a wall; a field; or any other structure for supporting a PV installation. Preferably, the pre-formed panel has a reduced weight compared to known panels provided with a glass panel. In preferred embodiments, the photovoltaic sandwich panel has a weight in a range between 1 and 50 kg/m², preferably between 5 kg/m² and 25 kg/m², most preferably between 2 kg/m² and 10 kg/m². Advantageously, panels with reduced weight, when mounted onto a structure, imply a reduced load onto the structure. This allows mounting an increased number of pre-formed solar panels and/or solar panels with increased dimensions onto a given structure, e.g. a rooftop, even for carriers with limited capability to support loads, e.g. roofs, such as corrugated roofs, of barns, halls, carparks and/or greenhouses. In some embodiments the specific weight, e.g. the weight per volume, of the panel may be such as to allow floating the pre-formed solar panel on a body of water, e.g. on a lake. Publication WO 2017/172056A1 describes photovoltaic module back sheets comprising thermoplastic vulcanizate compositions. It discloses hinged solar panels that can be folded for transport and deployed at different angles.

Document US 2018/316302 A1 discloses an angled solar panel comprising a front sheet, a back sheet, two layers of thermoplastic encapsulant and there-between alternating areas of thermoplastics and rigid polymers.

In a preferred embodiment, the stiffness of the panel between opposing ends is in a range between 100 - 5000 N/m. The plastically deformed section maintains the relative angle between the panel sections during normal operation, e.g. at common ambient temperatures, e.g. in a range between -40°C and 80°C. Preferably, the pre-formed solar panel is a free standing panel. A free standing panel may be understood to include panels capable of, in its mounting position, maintaining a given desirable relative orientation between its photo active region and support structure, e.g. maintaining the angle of its panel section provided with a photo active layer. Preferably the angle is in excess of 10° relative to level. In other words, a free standing pre-formed solar panel as disclosed herein may be mounted on to a carrier structure, e.g. a rooftop without a dedicated support structure, e.g. without a frame. Advantageously, PV installations without dedicated support structures may imply a reduced load onto the carrier structure, e.g. rooftop. This allows mounting an increased number of pre-formed solar panels and/or solar panels with increased dimensions onto a given structure, e.g. a rooftop.

Preferably, the section between the first and second planar section is plastically deformable at temperatures well above ambient operation temperature. Preferably, the plastically deformed section becomes plastically deformable above 100°C, preferably in range between 100°C and 200°C, while being rigid under normal operating temperatures, i.e. -40 to 80°C. The section between the first and second planar, i.e. the plastically deformed section, may be formed of a composition comprising a thermoplastic polymer. Suitable thermoplastic polymers include but are not limited to polyolefins (PO) such as ethylene vinyl acetate (EVA) and polypropylene (PP) and mixtures thereof.

In some preferred embodiments, the sections are formed with a common back panel. In other words, the at least a first planar section, the plastically deformed section and the second planar section comprised in the pre-formed solar panel are preferably formed with a common back panel formed of a composition comprising a thermoplastically deformable material, preferably a thermoplastic polymer. In such panels the plastically deformed section may be considered as a region over which the back panel is bent. By forming the pre-formed solar panel on a single, continuous back panel the panel may be manufactured by suitably thermoforming of a single pre-formed panel, e.g. planar panel. By forming the pre-formed solar panel from a continuous back panel, i.e. a common back panel, the pre-formed solar panel may form a continuous panel, e.g. a panel with continuous mechanical properties. As such the pre-formed solar panel may be used as a construction element, in particular for use as a water tight construction panel for spanning over roof openings, with a light weight relative to conventional roofing structures. In another or further preferred embodiment, the pre-formed solar panel may be formed by joining, e.g. welding, adjacent panels, optionally via a strip formed of a thermoplastically deformable material. In such panels the plastically deformed section may be a region over which panels are joined by a weld. Preferably, the adjacent panels are joined via a continuous weld. Providing a continuous weld may result in the formation of a pre-formed solar panel with mechanical properties, including water tightness similar to panels made from a common back panel.

In some preferred embodiments the pre-formed solar panel as described herein is, at least locally defined by the photovoltaic layer formed of a stack comprising the photovoltaic layer sandwiched, e.g. encapsulated, between the back panel and a protective front layer. In other or further preferred embodiments, pre-formed solar panel as described herein is, between the opposing ends of the panel formed of a stack comprising the photovoltaic layer, the back panel and a protective front layer. The protective front layer, is typically formed of an optically transparent composition comprising additives to protect the underlying PV-cells from external influences including but not limited to dust, sand, and weather (rain, hail, snow). The photovoltaic layer typically comprises a plurality of adjacent photovoltaic cells laid out in a pattern. Preferred PV-cells include polycrystalline and mono-crystalline Si-PV cells. It will be appreciated the present invention is not limited to crystalline Si-PV cells, also other types of cells may be used including thin film solar cells, as will be explained herein below. The back panel, like the front panel, protects the PV cells from external influences. In addition, the back panel, during manufacturing, may serve as a carrier on which the PV-cells are laid out. Further the back panel mainly determines the mechanical properties of the pre-formed panel as a whole. Proving a back panel with a stiffness in a range as described above mitigates damage to the PV cells in the solar panel that would otherwise result from bending and/or flexing, e.g. under the influence of static loads, e.g. a layer of snow, and under the influence of dynamic loads including wind load. Further the back panel along with the plastically deformed section contributes to maintaining the shape of the pre-formed solar panel. Optionally, the stiffness of the pre-formed solar panel may be improved by connecting the plastically deformed sections, e.g. via a separate connector element affixed to and connecting the back panels of the respective sections. Said connector element may be affixed by any suitable method, including gluing but is preferably affixed thermally, e.g. by welding. It will be appreciated that the plastically deformed section, particularly in embodiments formed with stiff, brittle PV-cells, like Si-PV cells is preferably provided between the photovoltaic cells. In other words, in such embodiments, the PV cells are not present in the plastically deformed section, e.g. the bend and/or the weld. In embodiments, provided with flexible PV cells, the PV cells may continue over a bend.

In an embodiment an embodiment of a preformed solar panel as specified is configured into a solar panel pyramid. This can be achieved with a preformed solar panel having at least three planar sections including said at least a first planar section and a second planar section. The at least three planar sections are provided as at least substantially triangular planar sections having a common top, and each planar section shares a first plastically deformed section with a first neighboring planar section, and shares a second plastically deformed section with a second neighboring planar section. The edges of the planar sections opposite the top define a base-plane of the solar panel pyramid. The plastically deformed sections include a plastically deformed section between the first end and the second opposing end of the first triangular planar section and the last triangular planar section of the preformed solar panel used to be configured into a solar panel pyramid. The wording "at least substantially triangular" implies that the planar sections are either triangularly shaped, or are triangles truncated by not more than 20% of their original height. The interior of the truncated pyramid therewith obtained can be easily accessed for maintenance. Also, this would avoid the occurrence of pressure differences in case of high wind velocities, therewith avoiding lift effects.

The pre-formed solar panel configured into a pyramid provides has a high structural integrity. Moreover, its configuration substantially reduces its sensitivity to wind forces. The number of (at least substantially) triangular planar sections may be 3 or higher. A number of 3, 4 or 6 is advantageous in that a planar area for solar energy harvesting can be efficiently covered with multiple identical species of the solar panel pyramid. Alternatively, a covering may be achieved with a combination of different embodiments of the solar panel pyramid for example using a combination of 8-sided and 4-sided solar panel pyramids. Regardless the shape of the solar panel pyramids, it may be contemplated to leave access space between neighboring species, to facilitate access. It is noted that in some embodiments, the number of triangular planar sections can be made substantially higher, e.g. in the order of tens or hundreds or more, so that the solar panel pyramid has the appearance of a solar panel cone. The size of the solar cells applied in the photovoltaic layer may be appropriately reduced, for example, to half or quarter cells. Also thin-film solar cells may be used for this purpose.

In embodiments, the base-plane of the solar panel pyramid is left open at its base plane. This embodiment is advantageous, in that a plurality of species of the solar panel pyramid can be stacked during transport, so that only a modest transport volume is required. Alternatively, the solar-panel pyramid may be closed at its base-plane. In this embodiment the solar panel pyramid has a good floating capacity, which is favorable for application in off-shore solar parks. In a very favorable embodiment, the solar panel pyramid is filled with a foam. The filling of foam can be provided at the destination, so that the solar panel pyramids can still be compactly stored and transported.

A solar-panel pyramid may comprising a control unit with a respective Maximum Power Point Tracker for each photovoltaic layer associated on triangular planar section, and having a controller for controlling said Maximum Power Point Trackers. The controller may for example have a communication interface for that purpose, which may operate wirelessly or may communicate information via the power line supplied by the solar-panel pyramid.

In an embodiment of the solar-panel pyramid, the photovoltaic layer of the triangular planar sections is preferably provided with one of back contact solar cells or thin film solar cells. This facilitates a step of providing for an external electrical connection, in that the photovoltaic layer may simply be laminated with a power collection back plane.

A solar-panel pyramid arrangement may be provided from a plurality of solar-panel pyramids. Mutually neighboring solar-panel pyramids may be mechanically coupled in a flexible manner. The solar-panel pyramid arrangement according to this embodiment is suitable for mounting on uneven surfaces, or to float on a water surface. The flexible coupling between neighboring solar-panel pyramids may be provided as an open structure to facilitate draining of rainwater. The flexible connections may be provided as a continuous sheet of an elastic material, such as rubber, or as discrete coupling elements, such as springs. In another embodiment the solar-panel pyramids in solar-panel pyramid arrangement are connected to a web. The web may be pre-tensioned to reduce the risk of collisions. Alternatively, buffer elements may be provided between neighboring solar-panel pyramids.

A solar-panel pyramid arrangement covering a larger surface area, may be provided with maintenance paths extending through the arrangement, to enable access of individual solar-panel pyramids. The maintenance paths may be mechanically coupled to adjoining solar-panel pyramids. This contributes to the mechanical integrity of the arrangement. Furthermore, in off-shore applications the maintenance paths may be supported by the floating solar-panel pyramids.

In a floating solar-panel pyramid arrangement, openings may be provided to allow access of external light to the water surface to the benefit of sea-life, e.g. fish, plants and algae.

Various options are possible to configure preformed solar panels into a solar panel pyramid. In one embodiment a preformed solar panel is provided with at least three, at least substantially triangular planar sections and which has each pair of mutually subsequent substantially triangular planar sections coupled by a respective plastically deformed section. A first edge portion of a first one of the substantially triangular planar sections defines the first end and a second edge portion of a last one of the at least substantially triangular planar sections defines the second opposing end.

The first and the second edge portion of the preformed solar panel are then contacted and heated for a time and temperature suitable to fuse the first one and the last one of the substantially triangular planar sections along a plastically deformed section to form the solar panel pyramid. A contacting of the first and the second edge portion may be optionally via a strip of a thermoplastically deformable material. In that case also that strip is heated according proper time and temperature conditions to achieve a fusing with the first and the second edge portion.

The preformed solar panel used for this purpose may be directly obtained by properly deforming an intermediary planar product. Alternatively, two smaller preformed solar panels that together have the number of substantially triangular planar sections of the preformed solar panel to be configured in a solar panel pyramid may be merged. Generally the smaller preformed solar panels can be obtained from a planar intermediary product with more efficiency. The first preformed solar panel has the first edge portion as well as a first intermediate edge portion. The second preformed solar panel has the second edge portion, and further has a second intermediate edge-portion, For example two preformed solar panels with each three substantially triangular planar sections may be merged to form a single preformed solar panel with six substantially triangular planar sections that is subsequently configured into a six-sided solar panel pyramid. The smaller preformed solar panel can be merged by contacting and heating the first and the second intermediate edge portion for a time and temperature suitable to fuse the first and the second preformed solar panel to obtain the preformed solar panel that is to be configure into a solar panel pyramid. A contacting of the first and the second intermediate edge portion may be optionally via a strip of a thermoplastically deformable material. In that case also that strip is heated according proper time and temperature conditions to achieve a fusing with the first and the second edge portion.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1A schematically depicts a perspective view of an embodiments of a pre-formed solar panel on a support plane;
FIG 1B-C schematically depicts cross-section side views of embodiments of a pre-formed solar panel on a support plane;
FIG 2A schematically depicts a cross-section side view of an embodiment of a pre-formed solar panel on a support plane;
FIG 2B schematically depicts a perspective view of an embodiment of a pre-formed solar panel with a side-panel;
FIG 3A schematically depicts a top-view of an embodiment of a pre-formed solar panel;
FIG 3B schematically depicts a cross-section side view of an embodiment of a pre-formed solar panel;
FIG 3C schematically depicts a detail side view of a mounting region of a pre-formed solar panel
FIG 4A-B schematically depicts a detail in side views of embodiments of pre-formed solar panel
FIG 4C schematically depicts a top-view of an embodiment of a pre-formed solar panel;
FIG 5A-B schematically depict a top-views of an embodiment of a pre-formed solar panel;
FIG 6A schematically depicts a cross-section side view of an embodiment of a pre-formed solar panel;
FIG 6B schematically depicts an exploded perspective view of an embodiment of a pre-formed solar panel;
FIG 6C schematically depicts a perspective view of an embodiment of a sandwich panel comprising a core layer sandwiched between fiber reinforced front and back sheets;
FIG 7A schematically depicts a perspective view of an embodiment of a core layer;
FIG 7B schematically depict detail cross-section side view of an embodiment around a plastically deformed section regions of an embodiment of a pre-formed solar panel;
FIG 8A schematically depicts a perspective view of an embodiment of an assembly of a plurality of pre-formed solar panels on a support plane;
FIG 8B-C schematically depicts top-views of embodiments of an assembly of a plurality of pre-formed solar panels;
FIG 9A-B schematically depict cross-section side views of embodiments of pre-formed solar panels assembled on a support plane;
FIG 10A-B schematically depict cross-section side views of further embodiments of pre-formed solar panels assembled on a support plane; and
FIG 11-12 schematically depict detail cross-section side views of the mounting regions of embodiments of pre-formed solar panels assembled on a support plane;
FIG. 13A 13I shows a method of mounting a plurality of solar panels on a roof;
FIG. 14A, 14B shows examples of solar panels having mutually cooperating mounting regions. FIG. 14C, 14D shows examples of solar panels having mounting regions cooperating with a capping element; FIG. 14E, 14F and 14G shows exemplary mounting regions in more detail; FIG. 14H shows a assembly of solar panels; FIG. 14I shows a detail of FIG. 14H;
FIG. 15 shows an alternative fixation of a pair of solar panels;
FIG. 16A, 16B respectively show a top view and a side view of a solar-panel pyramid;
FIG. 17 shows a perspective view of a solar-panel pyramid;
FIG. 18 schematically shows a solar panel pyramid provided with a control unit;
FIG. 19A-19D schematically show an aspect of a method of manufacturing a solar panel pyramid;
FIG. 20A, 20B, show examples of a solar panel pyramid arrangement;
FIG. 21A and 21B, show two examples of solar panel pyramids suitable to be arranged on a water surface;
FIG. 22 shows an intermediary product for use in manufacturing a solar panel pyramids as shown in FIG. 21A or 21B.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

As used herein photovoltaic cells be rigid cells, such as crystalline silicon solar cells (c-Si). c-Si cell thickness typically is in a range between 0.15 and 0.25 mm. Alternatively, the photovoltaic cells can be flexible in nature. Suitable PV cells include, but are not limited to thin film PV cells, such as thin film silicon, CIGS (Copper indium gallium selenide cells), OPV (Organic PhotoVoltaic cells), polymer solar cells, Perovskite solar cells, multi-junction cells, dye-sensitized cells, and quantum dot solar cells.

As used herein encapsulant layers are typically used with a thickness in a range between 0.05 and 2 mm, such as 1.2 mm, 1.1 mm 1 mm and 0.09 mm. Preferably, encapsulant layers may be thinner e.g. in a range between 0.2 mm and 0.5 mm, e.g. 0.4 mm.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

The invention is set out in the appended claims.

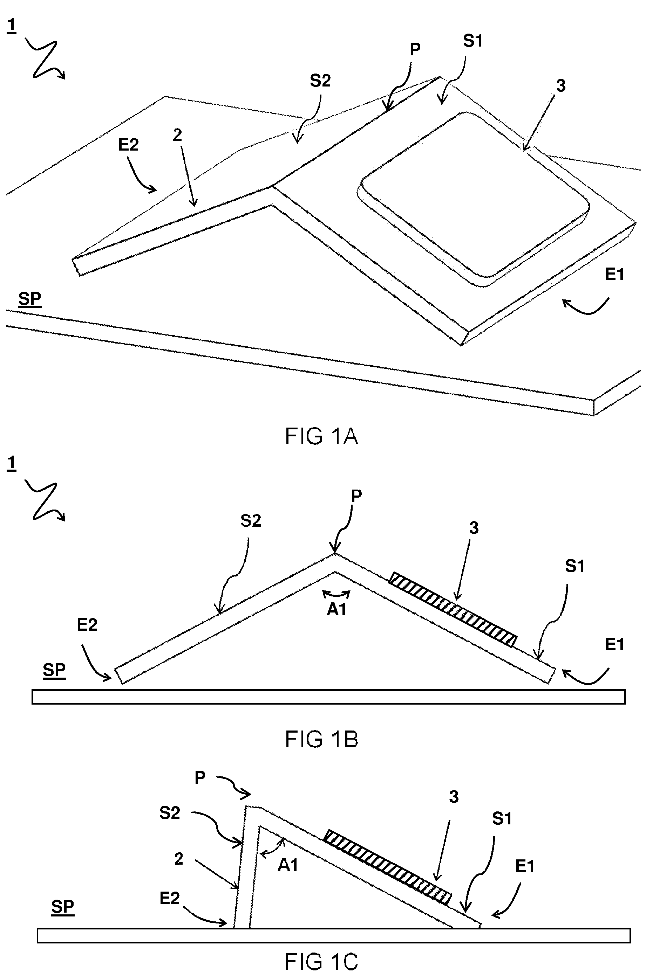

FIG 1A-C schematically depicts perspective and cross-section side views of an embodiment of a pre-formed solar panel 1 mounted on a support plane "SP". In a preferred embodiment, e.g. as shown, the solar panel is formed with a back panel 2 with, in a direction from a first end E1 to a second opposing end E2, at least a first planar section S1, a plastically deformed section "P" and a second planar section S2. In the embodiment shown, a photovoltaic layer 3 is provided on the second planar section S2. The plastically deformed section maintains the first and the second planar section relative to each other at an enclosed angle "A1" in a range between 30° and 170°, e.g. as shown in FIG 1B-C. In the embodiment as shown only section S1 is provided with a photovoltaic layer 3. In other or further preferred embodiments both sections may be provided with a photovoltaic layer. By providing both sections with a PV layer the photoelectric energy obtained per unit area of carrier may be increased.

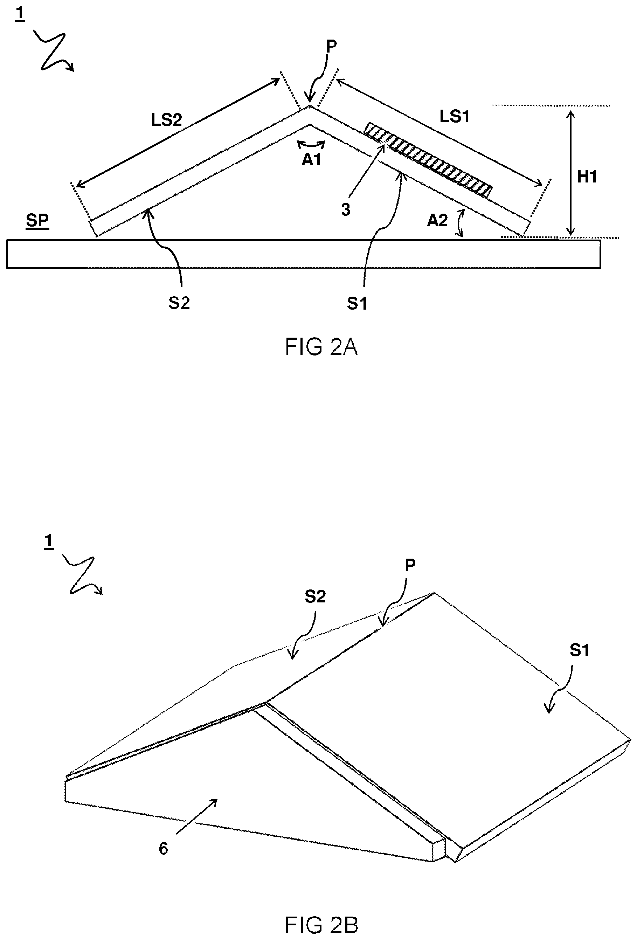

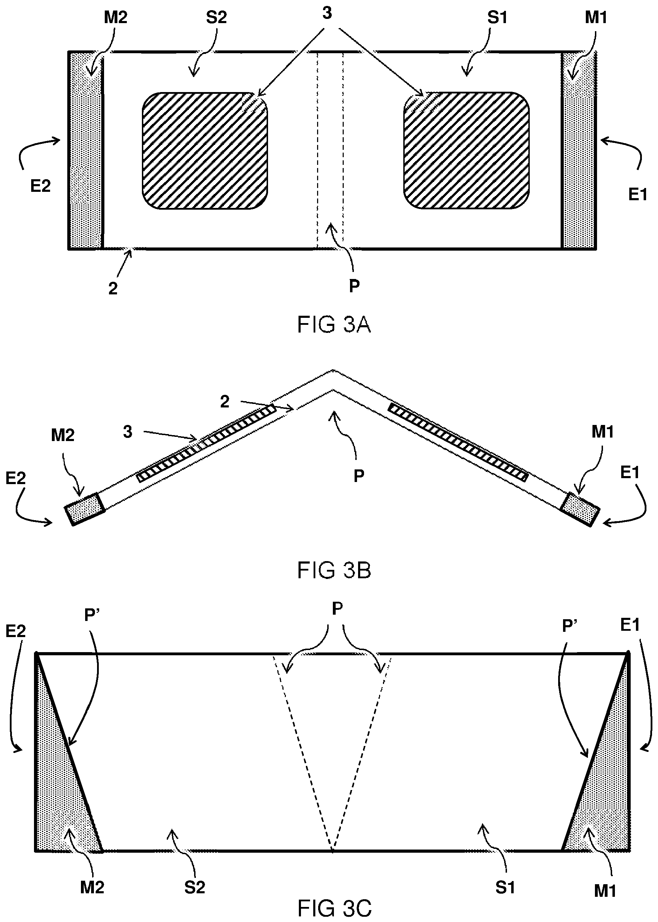

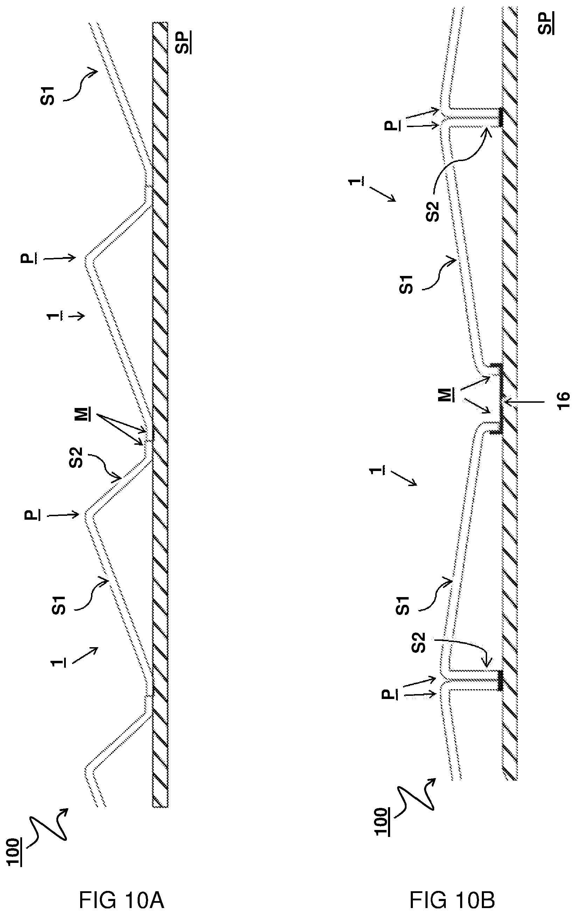

FIG 2A schematically depicts a cross-section side view of an embodiment of a pre-formed solar panel 1 with a height "H1" mounted on a support plane "SP". The length LS1 of the first planar section "S1"and the length LS2 of the second planar section S2 between the plastically deformed section "P" and the respective opposing end of panel are such that, when mounted, an enclosed angle A2 defined between the at least one of the sections with a photovoltaic layer 3 and the support plane "SP" is in a range between 10° and 90°. Providing the pre-formed solar panel 1 with the specified enclosed angle A1 and suitable section lengths LS1, LS2, the photovoltaic layer 3 may, when mounted, be positioned at angle with respect to level, i.e. the astronomical horizon, e.g. at an angle, in a range between 10° and 90°, e.g. 20° or 30°. By mounting the photovoltaic layer under an angle in said range efficient run-off of water, e.g. rain, may be ensured, mitigating fouling and/or reducing build-up of contamination on the photoactive surface of the panel. The height "H1" of the pre-formed solar panel depends on the length LS1, LS2 of the sections and the enclosed angle A1 between the sections. In practice, the length of the sections, the height of the pre-formed solar panel 1, and a dimension of the pre-formed solar panel 1 along the length of the plastically deformed section P may be tuned to the dimension of the carrier and/or to the relative orientation of the carrier. As known in the field, for a East-West orientation an about symmetric pre-formed solar panel 1 with photovoltaic layers on both sections may be preferred. For a North-South orientation symmetrical panels with a comparatively larger angle A1 may be preferred (the photovoltaic layer 3 mounted under a more shallow angle A2 with respect to the horizon. Optionally, asymmetric pre-formed solar panels, having a photovoltaic layer 3 on only one planar section may be used. For such panels the projected area of the section not provided with a photovoltaic layer 3 on the support plane "SP" is preferably minimized while maintaining a suitable angle for the panel with a photovoltaic layer 3. Such panels may be provided with a relatively sharp angle A1 between the sections, e.g. in a range between 30° and 130°, e.g. 60°, preferably in a range between 70° and 110°, e.g. 80° 100°. In practice, the height H1 of the pre-formed solar panel 1 is preferably selected in a range between 20 and 150 cm, typically in a range between 20 and 100 cm. Lower panels, have comparatively less photoactive surface due to edge and mounting effects. Higher panels have dimensions that reduce ease of handling, e.g. during manufacturing and/or assembly. Figures 3A-B, 5A-B, 6A, 7B, 8A-C, and 9A-B (all discussed in more detail later) depict further exemplary embodiments comprising photovoltaic layers 3 on both planar sections, and/or embodiments particularly suitable therefor. Figures 1C, and 10A-B (all discussed in more detail later), depict further exemplary embodiments comprising photovoltaic layers 3 on one of the planar sections, and/or embodiments particularly suitable therefor.

In another or further preferred embodiment, e.g. as shown in FIG 2B, the pre-formed solar panel 1 is provided with a side-panel 6 to reduce forces onto a mounted panel due to wind. By reducing the ability of wind to enter the space between the carrier on one hand and the planar sections (S1,S2) on the other hand load, e.g. upward load, and possible resulting damages therefrom are reduced. Said one or more side panel may be affixed to the panel by any suitable means including, but not limited to, bolting and gluing. In a preferred embodiment, the side-panel 6, like the back panel 2, is formed of a composition comprising a thermoplastically deformable material, preferably a polymer. This allows fusing, e.g. welding, of the side-panel 6 to the pre-formed solar panel 1, e.g. by fusing with the back panel 2. It will be appreciated that the side panel may be provided to the pre-formed solar panel 1 before or after the panels are mounted on a carrier. Accordingly, the present disclosure also relates to separate side-panels 6 dimensioned to be affixed to pre-formed solar panels as described herein.

FIG 3A and B schematically depict top-view and cross-section side view of an embodiment of a pre-formed solar panel 1 that comprises mounting regions M1, M2. In a preferred embodiment, e.g. as shown, the solar panel is formed with a continuous back panel 2 with in a direction from a first end E1 to a second opposing end E2 at least a first planar section S1, a plastically deformed section "P" and a second planar section S2. Onto the both planar sections a photovoltaic layer 3 is provided. The mounting regions are provided along an edge portion of the pre-formed solar panel 1 at positions along opposing ends E1, E2 of the back panel. FIG 3C schematically depicts a top-view of a further embodiment of a pre-formed solar panel;

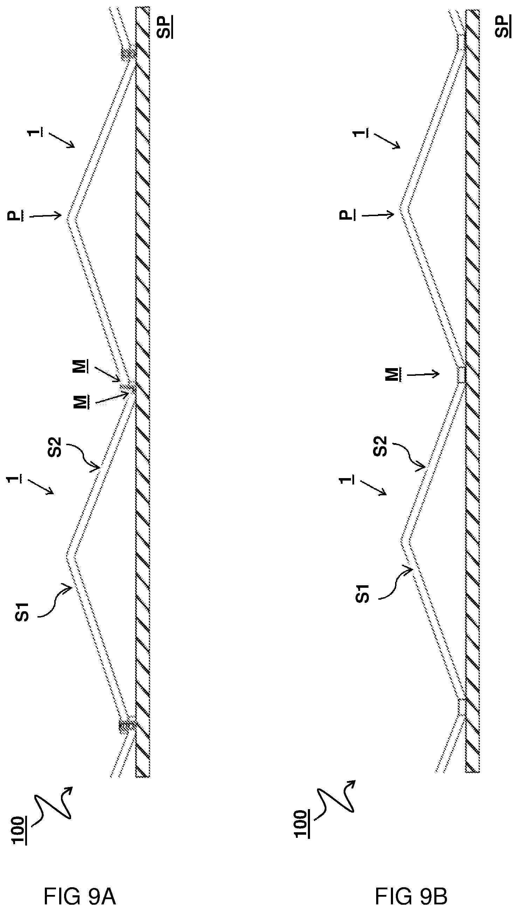

It will be appreciated that in some embodiments the mounting regions may simply be formed of end portions of the solar panel and/or its back panel and as such may not be directly identifiable as such. Depending on the indented application, e.g. mounting on a roof, and the availability of mounting means, such as clamps or slots, the panels may be mounted onto the carriers directly by their mounting regions. In other or further embodiment the mounting regions are provided with additional means and/or elements for affixing the panel to a carrier as will be explained in more detail later with reference to FIGs 9-12. In a preferred embodiment, the mounting regions comprise portions of the back panel along the opposing ends of the back panel that are plastically deformed, e.g. bent, at end portions of the panel and/or its back panel 2, e.g. as shown in FIG 3C. As such a further plastically deformed region P' may be identifiable between the mounting region and the remainder of the panel.

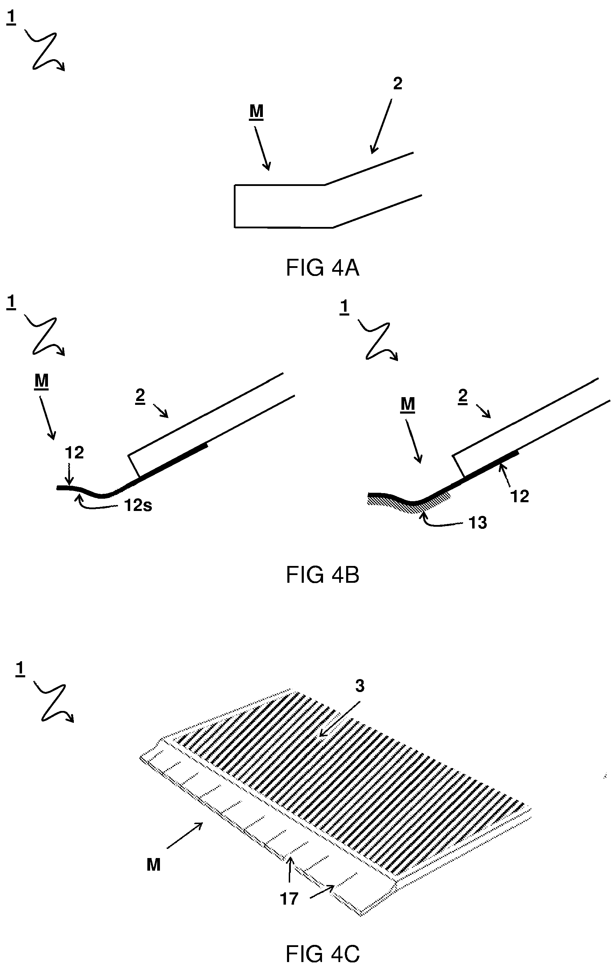

In another or further embodiment, e.g. as shown in FIG 4B, the mounting region includes a separated mounting element 12 durably attached thereto. Such element may be formed by a separate strip, e.g. band 12 that is durably connected along the edge portion of the solar panel. The strip may have a similar stiffness as the panel. Preferably, the strip is more flexible. For example, the strip may be formed of a cloth, woven, rubbery material. Advantageously, a flexible strip may adapt, e.g. flex, which facilitates affixing the pre-formed solar panel 1 to a surface of an uneven carrier, e.g. a corrugated roof. The strip may be provided with holes or openings to allow affixing the pre-formed solar panel to carriers, e.g. by bolting. Optionally, the strip may be provided with a further means 13, e.g. as shown in FIG 4B (right) for affixing the panel to a carrier. This means 13 include but are not limited to layer of glue, e.g. bitumen; and loop and hook fastener. The mounting element 12 may be durably attached to the panel, e.g. mounting region by any suitable means known in the field. In a preferred embodiment the mounting element is welded to the panel. Optionally, the mounting element is connected to the panel by a hook and loop fastener (Velcro). In some embodiments, e.g. as shown in FIG 4B, the mounting regions are provided with cuts or slits 17 extending in a direction away from the edge portion of the pre-formed solar panel. Mounting regions provided with slits or cuts are more flexible and capable of following a surface of an uneven carrier, compared to mounting regions without cuts or slits

It will be appreciated that the shape, dimension and relative orientation of the panels including the planar sections and deformed section P and/or the mounting regions are not to be construed as limited to the depicted embodiments. The disclosure also envisions differently shaped panels, in some embodiments, e.g. as shown in FIG 3C, wherein the plastically deformed section P connecting the planar sections S1, S2 and the plastically deformed section P' between the planar sections and the respective end portions E1,E2 of the panel are provided under an angle with resect to the end portions. In this way panels with PV cells provided on the planar sections may be provided, that when mounted, face other than opposing portions of the sky.

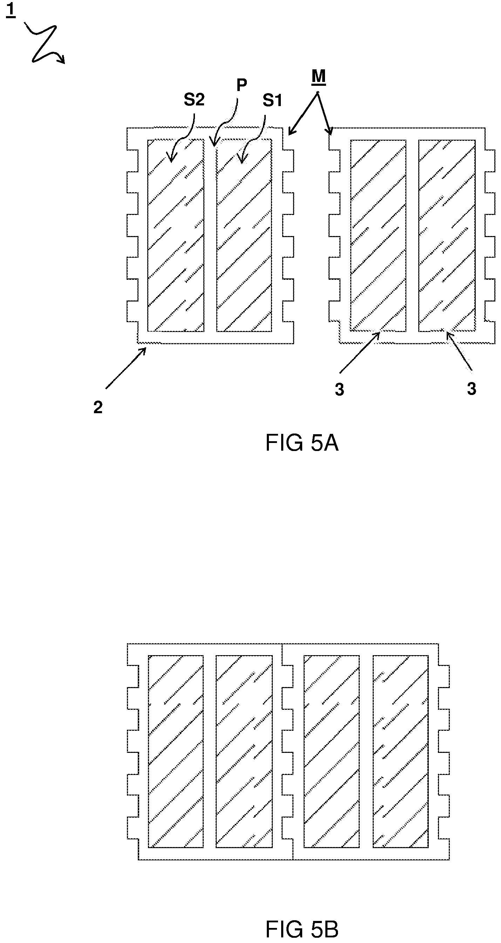

In other or further embodiments, e.g. as shown in FIG 5A and B, the mounting regions are formed in a pattern arranged to, when mounted, interlock with a patterned mounting region of an adjacent pre-formed solar panel 1. Alternatively, patterned mounting region may be formed to interlock with a matching separate mounting means.

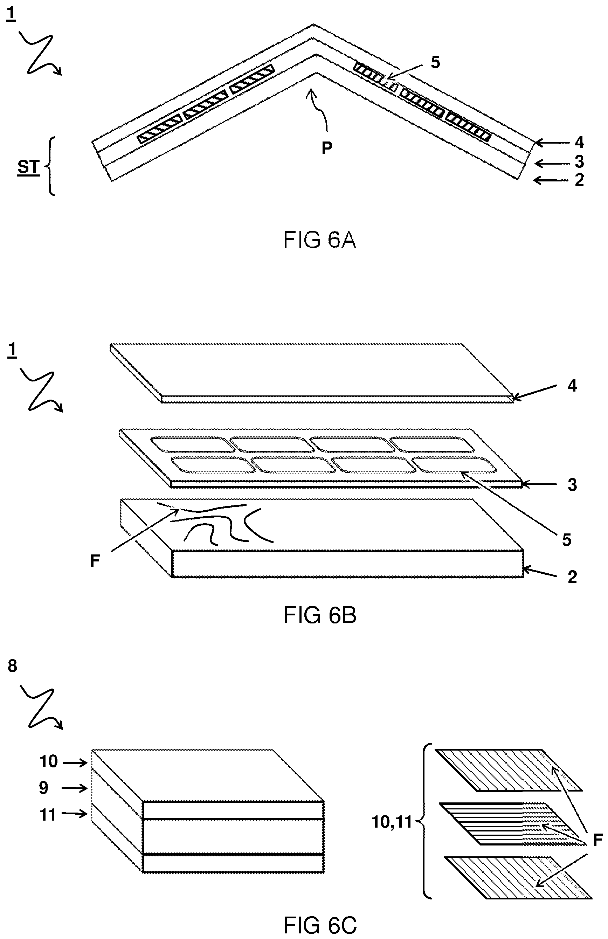

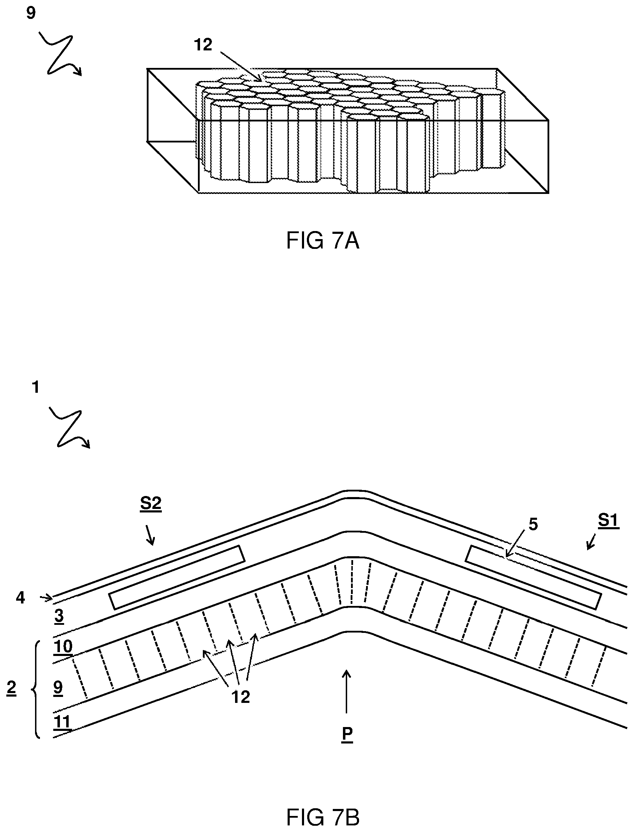

Now with reference to FIG 6A-C and FIG 7A-B a preferred embodiment of the pre-formed solar panel 1 will be described. As shown in FIG 6A and in an earlier application by the same inventors with number NL-2022468, the pre-formed solar panel 1 is preferably formed of a stack ST comprising the photovoltaic layer 3 sandwiched between a back panel 2 and a protective front layer 4. Preferably, the photovoltaic layer 3 comprises a plurality of encapsulated photovoltaic cells 5, e.g crystalline Si PV cells. Preferably, the protective front layer is formed from a compound comprising a first thermoplastic polymer. The back panel is also formed of a composition comprising a second thermoplastic polymer. Advantageously such flat versions of such panels, e.g. without plastically deformed region P, may be manufactured in a efficient process using one or more lamination steps. Using a thermoforming process the flat panels may be thermoformed to form the pre-formed solar panels as described herein. It will be appreciated that, as explained hereinabove, the PV cells 5 are preferably laid-out in a pattern such that cells and/or electrical interconnects are not provided at the region of the plastically deformed section P. In other words, the plastically deformed section P is preferably provided between the photovoltaic cells 5. The back panel 2 is preferably a fiber F reinforced panel. The reinforced back panel is a compound material comprising a second thermoplastic polymer and a reinforcement material, preferably a fibrous reinforcement material F. In other or further preferred embodiments the back panel is a sandwich panel 8 comprising a core layer 9 sandwiched between fiber reinforced front and back sheets 10,11. In turn, the fiber reinforced front and back sheets 10,11 may be a multi-layered composites, e.g. fiber reinforced tape layers stacked in a cross-ply orientation. In some embodiments, the core layer 9 may be a dense layer, e.g. a solid layer of a thermoplastic polymer composition. In some preferred embodiments the core is a honey comb panel 12, e.g. as shown in FIG 7A, wherein the honey comb panel is formed of a thermoplastically deformable polymer composition. By using a honey comb panel the back panel, including the fiber reinforced front and back sheets may be provided with the desired strength. By forming the back sheet from thermoplastically deformable materials, backsheets may be thermoformed into a desired position to form a pre-formed solar panel 1 as described herein. Figure 7B is a cross-section side-view that depicts a detail of a photovoltaic sandwich panel comprising a photovoltaic layer 3 provided between a protective front layer 4, and a fiber reinforced back layer 2, wherein the fiber reinforced back layer is a sandwich panel comprising a honey comb core layer 9 sandwiched between a fiber reinforced thermoplastic top layer 10 and a fiber reinforced thermoplastic polymer bottom layer 11. Upon locally heating the panel above a softening point of the respective layers the panel is formed, e.g. bent, to form a pre-formed solar panel 1, with an enclosed angle A1 as specified herein.

As described above, the height H1 of the pre-formed solar panel 1 depends on the length LS1, LS2 of the sections S1,S2 and the angle between them. In practice the height preferably varies in a range between 20 and 150 cm. In some preferred embodiments the lengths LS1, LS2 of the sections S1,S2 between the plastically deformed section P and the respective opposing end of back panel 2 are in a range to define a height of the pre-formed solar panel, in a range between 20 and 80 cm, preferably in a range between 30 and 50 cm. Lower pre-formed solar panels and assemblies thereof are advantageous for being less susceptible to wind loads.

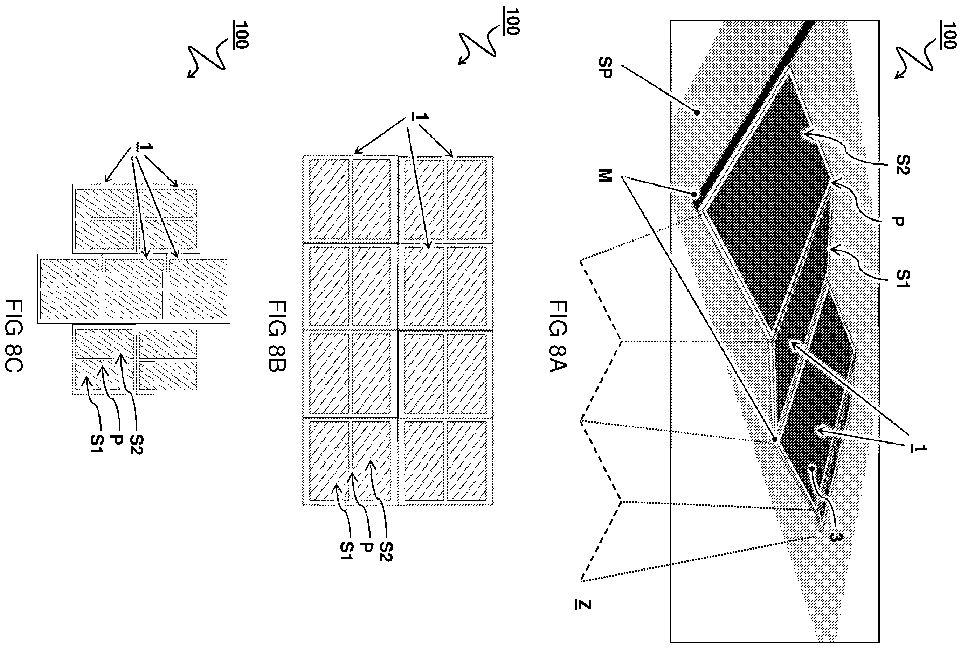

FIG 8A schematically depicts a perspective view of an embodiment of an assembly 100 of a plurality of pre-formed solar 1 panels on a support plane SP of a carrier. The support plane may be understood to be a surface of any suitable carrier including, but not limited to a roof (flat roof, slanted roof); a wall; a field; or any other support structure for a PV installation (e.g. poles). FIGs 8B-C schematically depict top-views of embodiments of an assembly 100 of a plurality of pre-formed solar panels 1. As described above, the pre-formed solar panels 1 described herein may be used to assemble a photoelectric energy harvesting installation 100 on a carrier wherein the planar section S1, S2, including photoactive regions 3 are oriented in a so-called zig-zag "Z" orientation, e.g. as shown in FIG 8A. By using the pre-formed solar panels according to the invention, e.g. without using a dedicated mounting frame, the installation time and/or costs to form such assembly may be reduced. By orienting the panels in a zig-zag orientation the total number of panels per unit area of carrier may be increased, thus increasing attainable photoelectric output on a given carrier, e.g. a rooftop with limited total surface area. In a preferred embodiment adjacent pre-formed solar panels 1 are durably joined, e.g. fused, to form a continuous structure shielding the carrier at locations below the continuous structure from water. Adjacent panels may be joined to form an array with a simple pattern of rows and columns, e.g. as in FIG 8B. Spaces, i.e. mounting regions M1, M2, between adjacent panels may be sufficiently wide for a person to walk on, e.g. during installation and/or maintenance. In a preferred embodiment, the panels many be joined in an array formed of staggered rows, e.g. as in FIG 8C. Independently, of the lay-out of the array pre-formed panels, e.g. at the end or beginning of a row may be provided with a side-panel 6 as described above.

FIGs 9 and 10 schematically depict cross section side views of exemplary embodiments of assemblies 100 of pre-formed solar panels 1 on a support plane "SP". In FIGs 9A-B the panels 1 comprised in the assembly are approximately symmetric and the first and second planar sections S1,S2 are of about equal length. It will be appreciated that in such assemblies either section, preferably both sections may be provided with a photovoltaic layer 3. The first and second planar sections S1,S2 in the exemplary embodiments depicted in FIG 10A-B are dimensioned as an asymmetric panel in which preferably only one of sections is provided with a photovoltaic layer 3.

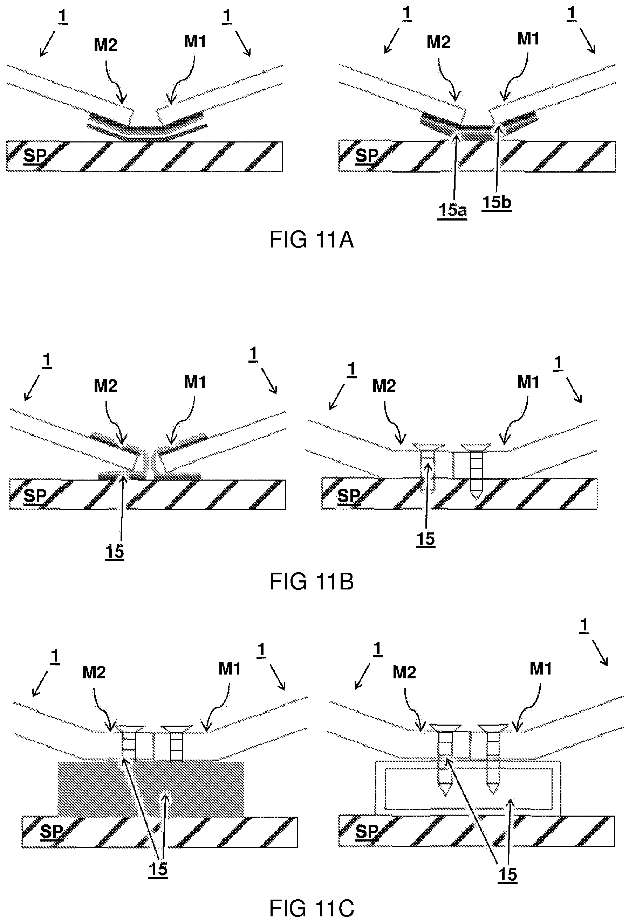

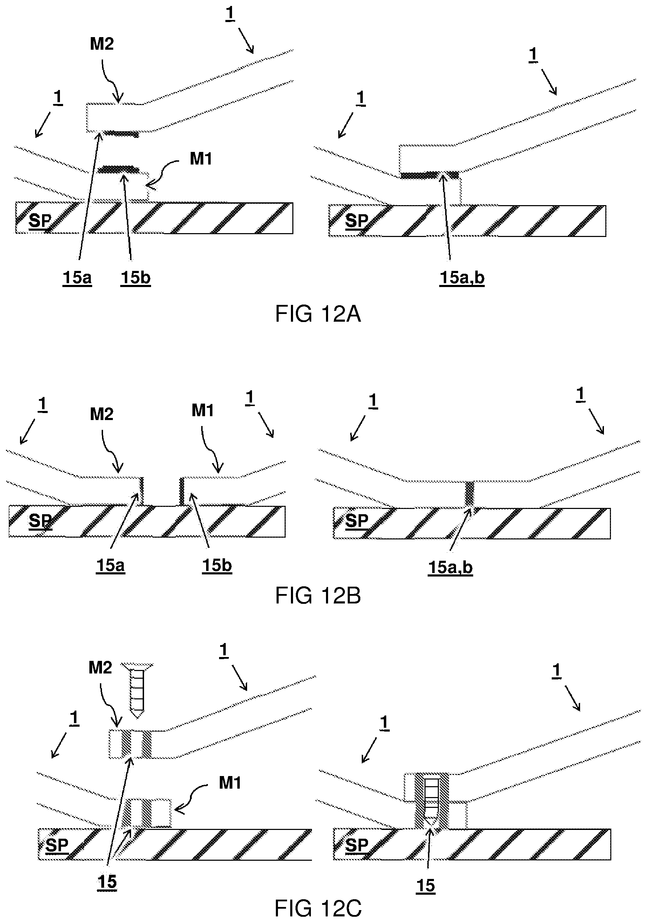

FIGs 9-12 further depict a broad range of exemplary embodiments of differently shaped and/or dimensioned mounting regions M, mounting elements 12, and/or mounting means 13. In one embodiment, adjacent panels may be joined with an overlap, e.g. with overlapping mounting regions, e.g. as shown in FIGs 9A, 12A, and 12C. In another or further embodiments adjacent panels may be joined with touching edge portions, e.g. as shown in FIGs 10A, and 12B. Joining may be understood to include gluing and welding. By mounting adjacent panels in a partly overlapping fashion and/or by joining panels an assembly 100 with improved overall integrity may be attained as in such assemblies individual panels impart strength from adjacent panels. Further, mounting adjacent panels in a partly overlapping fashion and/or by joining panels may result in the formation of a watertight assembly which in it self, or in part, may be used to cover an opening in, for example, a building. In other words, the pre-formed solar panel 1 of the invention may advantageously be used as a construction panel. Simply mounting the panels in adjacent positions, e.g. as shown FIGs 11B is also envisioned but may not lead to the formation of a watertight assembly. Optionally, adjacent panels may be joined before or after mounting, either directly, e.g. by welding edges of adjacent back panels directly together of, alternatively via an strip 12, 12a, e.g. as shown in FIG 9B, 10B and 11A. The strip may be affixed to the mounting surface and may serve as gutter to drain off excess water, e.g. rain, from the assembly 100. Further optionally the panels may be mounted on a carrier rail 16. Affixation may be obtained by means 13 described herein and/or means known in the field. These include, but are not limited, to screwing, nailing, bolting and the like, as shown in FIG 9A, FIG 11B (right), 11C, and 12C. These further include hook-and-loop fasteners (Velcro) and the like, e.g. as shown FIG 11A, 11B (left) as wells as push buttons and glue, such as bitumen, e.g. as shown in FIGs 11A and 12A.

A further aspect of the present disclosure relates to methods for the manufacturing of a pre-formed solar panel, preferably a pre-formed solar panel as described herein. A method for manufacturing a pre-formed solar panel as described herein comprises:
- providing a thermoplastically deformable back panel (2)
- plastically deforming, preferably thermoplastically deforming a section (P) of the back panel (2) to form at least a first and second planar sections (S1,S2) separated by the plastically deformed section (P), and wherein the plastically deformed section maintains the first and the second planar section relative to each other at an enclosed angle (A1) in a range between 30° and 170°. The photovoltaic layer 3 may be provided before or after setting the angle between the sections. Preferably, the method comprises providing a planar thermoplastically deformable solar panel, as described above with reference to FIGs 6 and 7.

A further method for manufacturing a pre-formed solar panel (1) as described herein comprises:
- providing at least a first and second planar solar panels each comprising a thermoplastically deformable back panel (2), e.g. planar thermoplastically deformable solar panels, as described above with reference to FIGs 6 and 7.
- contacting under a pre-defined angle, optionally via a strip of a thermoplastically deformable material, and heating edge portions of the thermoplastically deformable back panels of first and second planar solar panels and optionally the strip of a thermoplastically deformable material, for a time and temperature suitable to fuse the panels along a plastically deformed section (P) to form the pre-formed solar panel comprising at least a first and second planar sections (S1,S2) separated by the plastically deformed section (P), and wherein the plastically deformed section maintains the first and the second planar sections relative to each other at an enclosed angle (A1) in a range between 30° and 170°.

It will be appreciated that thermoplastic deformation, e.g. bending, may include heating to a temperature above a softening point of the panel. Pressure applied to the softened panel(s) to position the planar sections under a desired angle. Positioned panels and or panel sections are cooled back to a temperature below the softening point to durably fix the sections under the set angle.

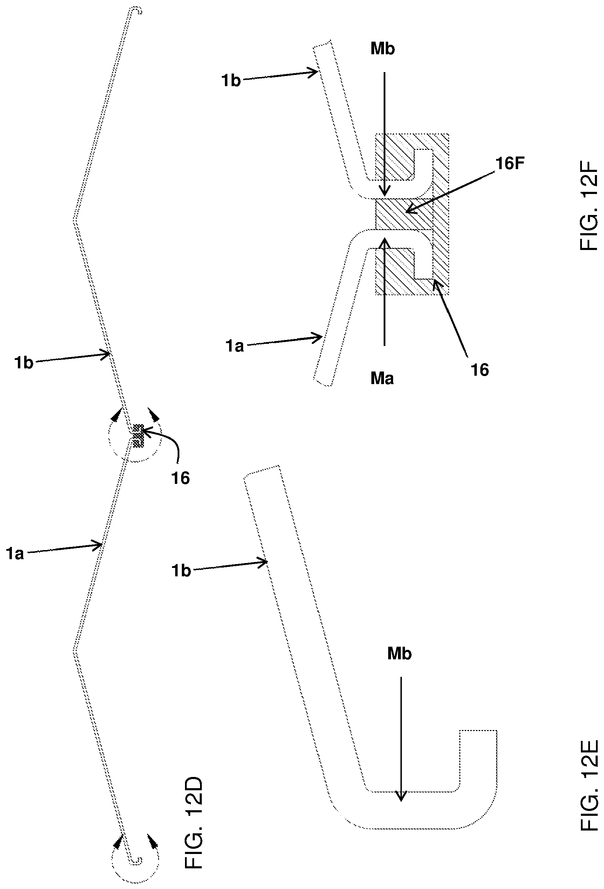

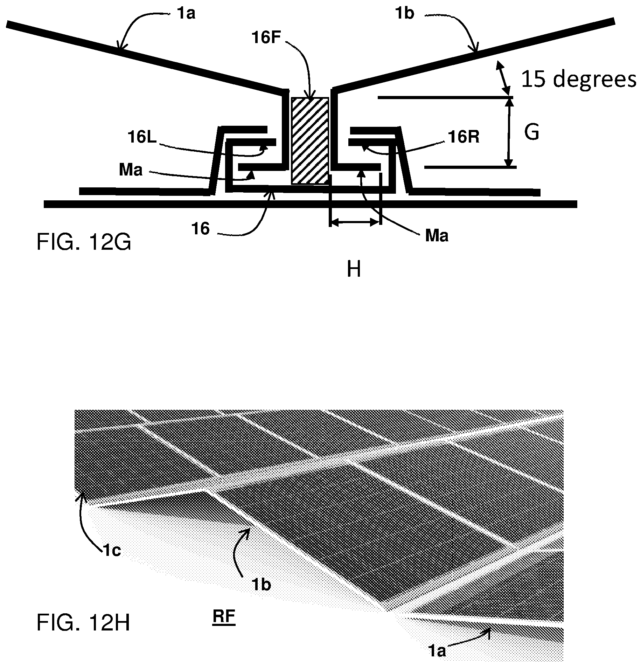

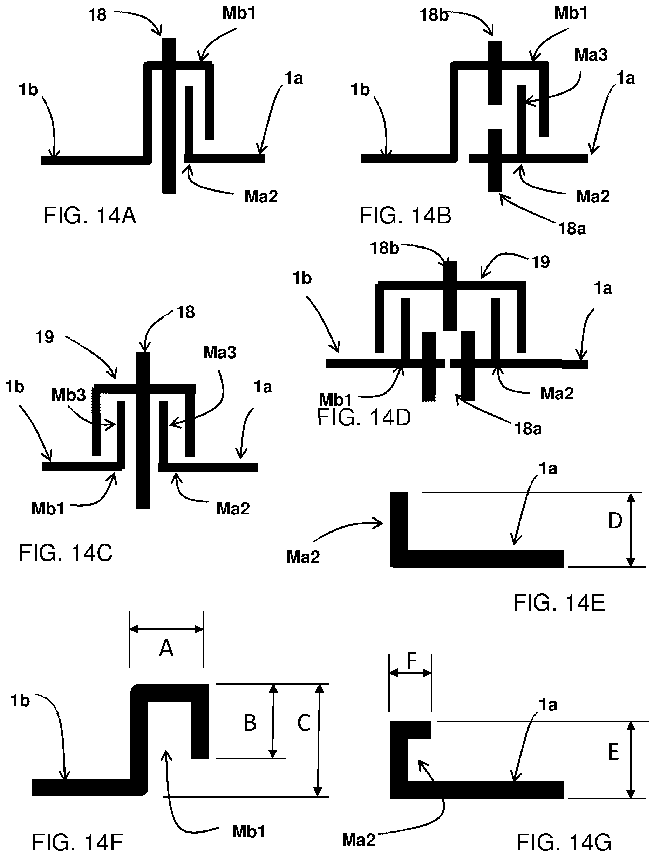

FIG. 12D, 12E, 12F, schematically shows two preformed solar panels 1a, 1b of an assembly that are fixed to each other and to the roof using a rail 16. As shown in more detail in FIG. 12F and also in FIG. 14B, the rail 16 has at least one, in this case two inwardly pointing edges 16L, 16R. The mounting sections Ma, Mb of the pre-formed solar panels 1a, 1b have a backwardly curved edge that cooperates with the inwardly pointing edge (See the detail in FIG. 12E for panel 1b). In the embodiment shown in FIG. 12F and 14B, the backwardly curved edge of the mounting section Ma, Mb is clamped against the inwardly pointing edge of the rail with a filling piece 16F mounted in the rail 16. FIG. 12G shows the cross-section of FIG. 12F in still further detail. Solar panels 12a, 12b, 12c etc may be assembled on a roof therewith, as shown in FIG. 12H. In the example shown, the solar panels are arranged at an angle of about 15 degrees, therewith the efficiency of the panels is relatively insensitive to the angle of incident solar radiation..

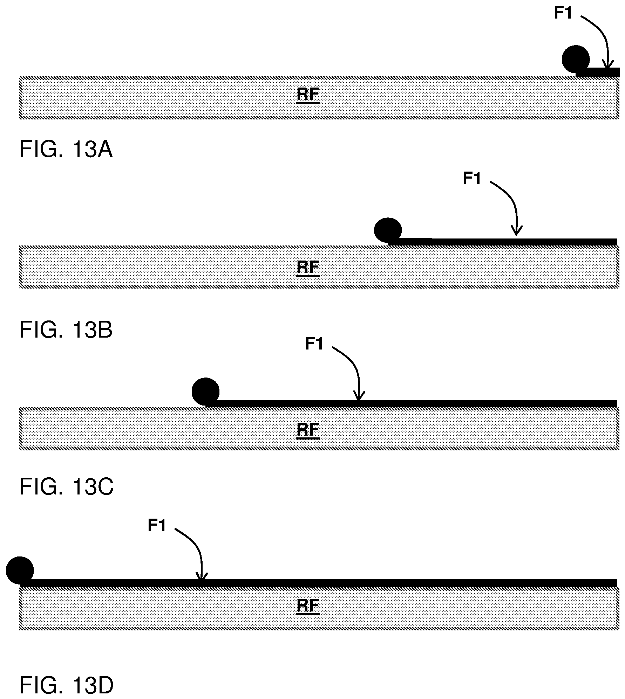

FIG. 13A - 13I shows an embodiment of a method of assembling pre-formed solar panels 1a, 1b on a roof RF.FIG. 13A- 13D shows how a strip, e.g. having a width of about 5 to 15 cm, e.g. of about 10 cm, of a first Velcro component F1 is rolled over the surface of the roof and adhered therewith. In an embodiment, this first component F1 may be comprised in the roof membrane (e.g. from bitumen, PVC, EVA, EPDM) already.

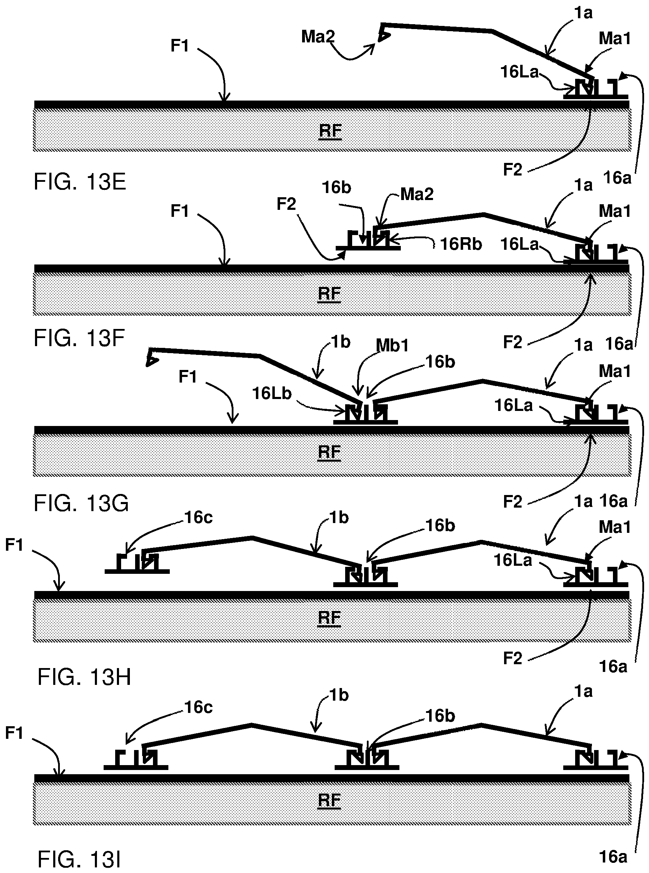

In a subsequent stage rails 16a, 16b,..etc having a bottom surface with the complementary Velcro component are attached to the first Velcro component. Preferably the first Velcro component comprises loops and the second component F2 comprises hooks. FIG. 13E shows a first assembly stage, wherein rail 16a is attached with a layer of the second Velcro component F2 to the first Velcro component F1 on the surface of the roof RF an wherein a first preformed solar panel 1a is hooked with its mounting section Ma1 behind the inwardly pointing edge 16La of the rail 16a. Instead of a rail, which extends over the full length of the panel, alternatively a bracket may be used having a dimension along the Velcro component in the order of about 10 to 30 cm, depending on an expected wind load, and having a dimension transverse thereto corresponding to the width of the Velcroc omponent.

FIG. 13F shows a second stage, wherein the opposite mounting section Ma2 of the first preformed solar panel 1a is hooked behind backwardly curved edge 16Rb of a next rail 16b. The rail 16b is subsequently attached with its the second Velcro component F2 to the surface of the roof RF, as shown in FIG. 13G. As also shown in FIG. 13G, a next preformed solar panel 1b is hooked with its mounting section Mb1 behind the inwardly pointing edge 16Lb of the rail 16b. As shown in FIG. 13H, 13I, the preformed solar panel may mounted to a further rail 16c in the same way as shown in FIG 13F, 13G for the preformed solar panel 1a. It is noted that in some embodiments, the rails 16a, 16b, 16c etc may first be mounted to the surface of the roof RF, before coupling the preformed solar panel 1a, 1b, etc, ... thereto. For that purpose, either the mounting regions of the preformed solar panels, or the backwardly curved edges of the rails or both may be of an elastic material. The method described with reference to FIG. 13A-13I allows a very efficient assembly process. Alternatively however, assembly elements, such as rails or brackets may be fixed in other manners to a roof, e.g. by adhering, or fixed by a screw connection.

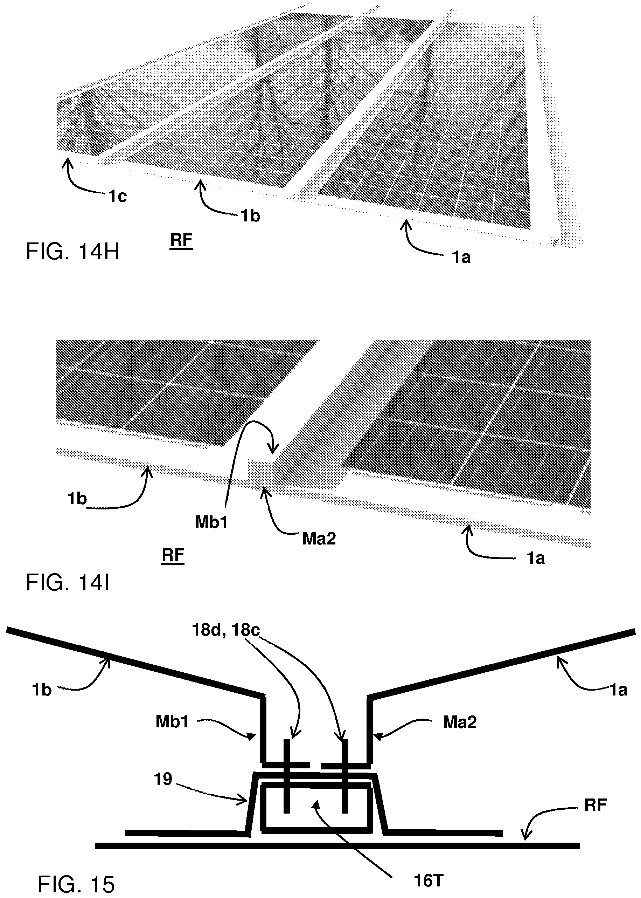

FIG. 14A and 14B show two embodiments of adjacent preformed solar panels 1a, 1b fixed to each other by their mounting region Ma2, Mb1. In the embodiment of FIG. 14A, the first preformed solar panel 1a has an upwardly bent mounting region Ma2 as shown in FIG. 14E. The second preformed solar panel 1b has a mounting region Mb 1 formed as a hook that grips around the upwardly bent mounting region Ma2 of the first preformed solar panel 1a. The first mounting region of the second preformed solar panel 1b is shown in more detail in FIG. 14F. The preformed solar panels 1a, 1b are jointly attached to the roof by a fixation means 18, such as a screw or a bolt. FIG, 14H is a picture of preformed solar panels 1a, 1b, 1c that are assembled to a roof RF with the connection of FIG. 14A, in this case without visible fixation means. FIG. 14I show a detail of this connection, between the preformed solar panels 1a and 1b in FIG. 14H. FIG. 14G shows an example of a preformed solar panel 1a with a backwards bent mounting region Ma2 which may cooperate with a corresponding mounting region of another panel gripping therein.

FIG 14B shows a variation of the embodiment of FIG. 14A. Parts therein corresponding to those in FIG. 14A have the same reference number. In the variation shown in FIG. 14B, the mounting region Ma2 of preformed solar panel 1a comprises an upwardly pointing edge part Ma3, which is fused to the end of the panel 1a. The preformed solar panels 1a, 1b are jointly attached to the roof by mutually cooperating fixation means 18a, 18b, such as a bolt and nut, or by elements that form a snap connection.

In the embodiment of FIG. 14C neighboring panels 1a, 1b have the same upwardly bent mounting region Mb1, Ma2 as shown in FIG. 14E, and a capping member 19 is fixed over these upwardly bent mounting region Mb1, Ma2 by fixation means 18. In the variation shown in FIG 14D parts corresponding to those in FIG. 14C have the same reference number. In the variation shown in FIG. 14D, the mounting regions Ma2, Mb1 of preformed solar panela 1a, 1b comprise an upwardly pointing edge part Ma3, Mb3, which is fused to their end. The preformed solar panels 1a, 1b are jointly attached to the roof by a capping member 19 and mutually cooperating fixation means 18a, 18b, such as a bolt and nut, or by elements that form a snap connection.

FIG. 15 shows a still further example. Parts therein corresponding to those in FIG. 14A-14I have a same reference number. In the embodiment shown therein a tubular mounting element 16T with rectangular cross-section is mounted to roof RF, for example with Velcro tape or by other means. The tubular mounting element 16T is capped by capping element 19, which may also be fixed to the roof by an adhesive or by Velcro tape or the like, and which may also serve for fixation of tubular mounting element 16T. In some cases this fixation may be sufficient, so that no further means are required for fixation of the tubular mounting element 16T. Finally, the preformed solar panels 1a, 1b are mounted with their mounting regions Ma2, Mb1 to the tubular mounting element 16T, for example with screws 18c, 18d.

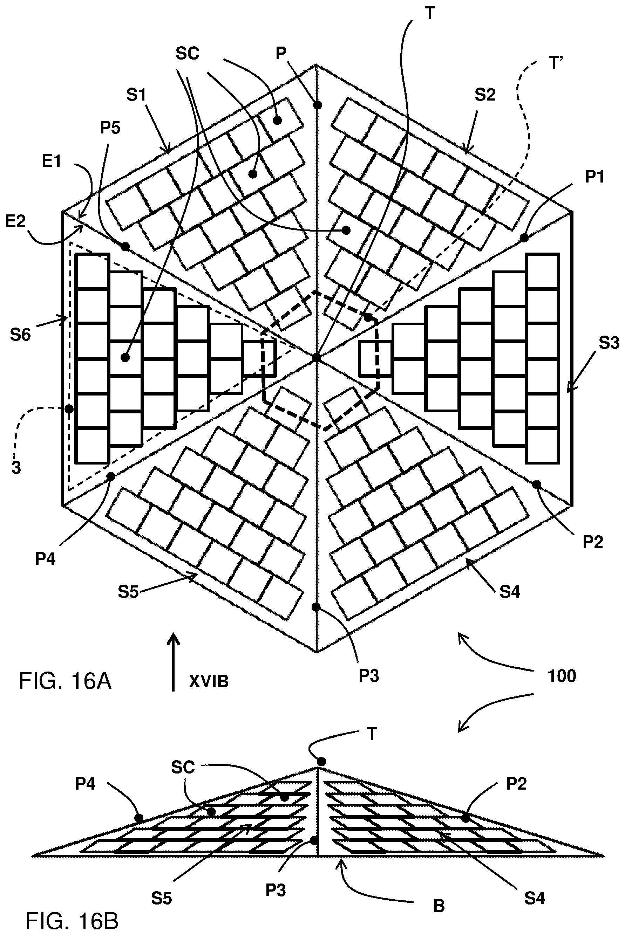

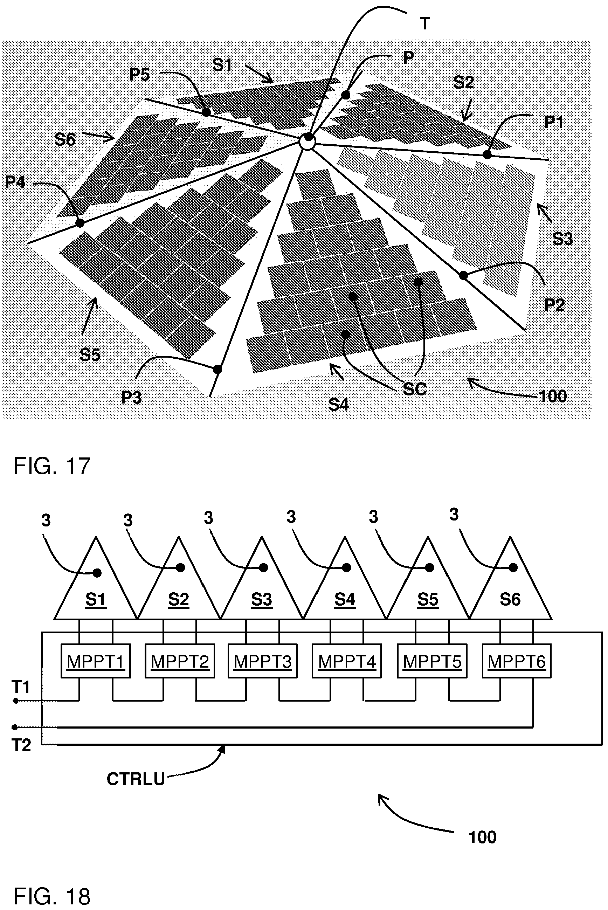

In an embodiment as shown in FIG. 16A, 16B and FIG. 17 a preformed solar panel is configured into a solar panel pyramid 100. Therein FIG. 16A shows a top-view, FIG. 16B shows a side-view according to XVIB in FIG. 16A, and FIG. 17 shows a perspective view. The preformed solar panel is configured into a solar panel pyramid 100 comprises at least three, in this case six triangular shaped planar sections S1, S2, ..., S6. The triangular planar sections having a common top T. In this example, the sections S1 may for example have a side remote from the top that has a width in the order of 100 to 150 cm, for example about 125-130 cm. Solar cells, e.g. 21 rectangular cells having a size of about 160x160 mm may be arranged thereon as a first row of 6 cells, a second row of 5 cells etc. In this arrangement, a distance of the top of a triangular planar section to the middle of its base can be of the same order of magnitude as the dimension of its base. Therewith the height of the solar panel pyramid constituted from the triangular planar sections S1,..., S6 is in the order of halve the height of the base side, in this example about 60 to 70 cm, and the angle between neighboring triangular planar sections is in the order of 140 degrees. If the solar pyramid is provided on a water surface, then if necessary, a floating element, e.g. an airbag may be accommodated within the pyramid, so as to lift all solar cells sufficiently above the water surface. Each planar section (e.g. S2) shares a first plastically deformed section (e.g. P) with a first neighboring planar section (e.g. S1), and shares a second plastically deformed section (e.g. P1) with a second neighboring planar section (e.g. S2). The edges of the planar sections S1-S6 opposite said top T define a base-plane B of the solar panel pyramid 100. The plastically deformed sections P, P1, P2,...P5, include a plastically deformed section P5 between the first end E1 and the second opposing end E2. Each triangular section S1, ...,S6, has a photovoltaic layer 3, as for example shown for section S6, having a plurality of photovoltaic cells SC, which are typically arranged in series. It is noted that a truncated pyramid may be formed from truncated triangles, and having a top T' as schematically indicated in FIG. 13A.

FIG. 18 schematically shows a solar panel pyramid provided with a control unit CTRLU. The control unit CTRLU has a respective Maximum Power Point Tracker MPPT1,...,MPPT6 for each photovoltaic layer 3 associated with a respective substantially triangular planar section S1, ..., S3. The outputs of the trackers are arranged in series between output terminals T1, T2.

Alternatively, it could be contemplated to simply arrange the photovoltaic layers of the sections S1,...,S6 in series, bridging each of the sections with a bypass diode. However in that case sections that have a lower light exposure would limit the power output or not contribute any output power (depending on the type of bypass device), whereas in the embodiment of FIG. 18 they still do provide an optimal contribution.

In another configuration, the photovoltaic layers of the section S1,...,56 are connected in parallel. In this case the sections can deliver their contribution in proportion to the light exposure. As compared to the configuration of FIG. 18, however, this parallel configuration would operate at a lower output voltage and a higher output current, and therewith result in higher resistive losses and the requirement of thicker, more expensive cables.

In a still further configuration, the corresponding sections of mutually different solar panel pyramids are arranged in series. This would have the advantage that the serial connection is provided for solar panel elements having a comparable light exposure, so that all sections efficiently contribute. This configuration however involves significant cabling costs, as a multitude of cables has to be provided. In the case of a hexagonal pyramid arrangement a first set of two cables (+ and -) would be required for the S1 sections of a series of pyramids, a second set for the S2 sections, etc., resulting in a total of six sets of cables.

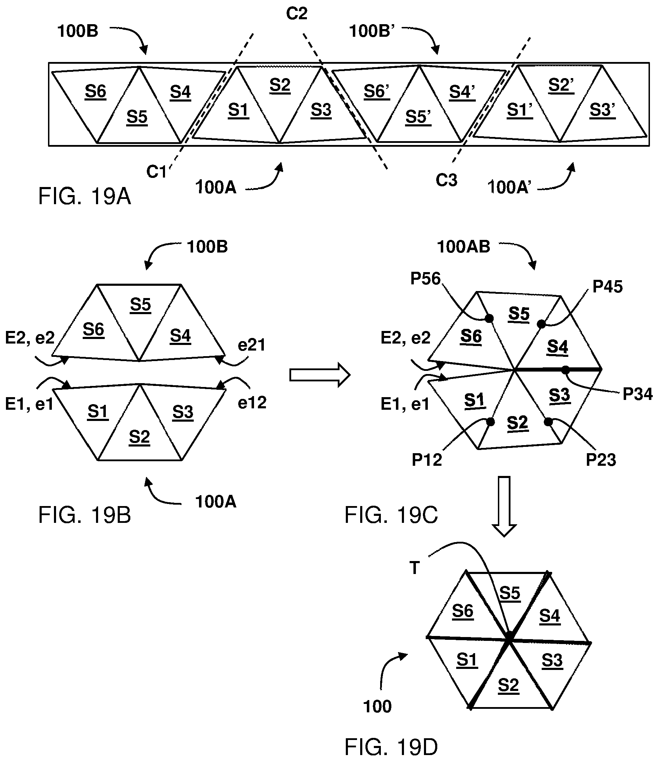

FIG. 19A-19D schematically show an aspect of a method of manufacturing a solar panel pyramid. Therein FIG. 19A shows how preformed solar panels 100A, 100B, 100A', 100B' etc,... each having three, triangular planar sections S1-S3, S4-S6, S1'-S3', S4'-S6' are manufactured as portions of a planar semi-finished product. These portions 100A, 100B, 100A', 100B' can be cut along lines C1, C2, C3 from the planar semi-finished product with very low material losses.

FIG. 19B shows how two preformed solar panels 100A, 100B are mutually positioned to be subsequently merged into a larger preformed solar panel 100AB, as shown in FIG. 19B. As shown in FIG. 19B, 19C, the two preformed solar panels 100A, 100B are merged by contacting the first intermediate edge portion e12 of portion 100A and the second intermediate edge portion e21 of portion 100B and heating these edge portions e12, e21 for a time and temperature suitable to fuse the first and the second preformed solar panel 100A, 100B to obtain the preformed solar panel 100AB of FIG. 19Cwith at least three, at least substantially triangular planar sections. Optionally, contacting, may be achieved via a strip of a thermoplastically deformable material, in that case also that strip is to be heated, at least at the locations where it contacts the intermediary edge portions e12, e21, for a time and temperature suitable to fuse therewith.

In the final step, shown in FIG. 19C, 19D, in the same manner, the remaining edge portions e1, e2 of preformed solar panel 100AB are connected to form the solar-panel pyramid 100.

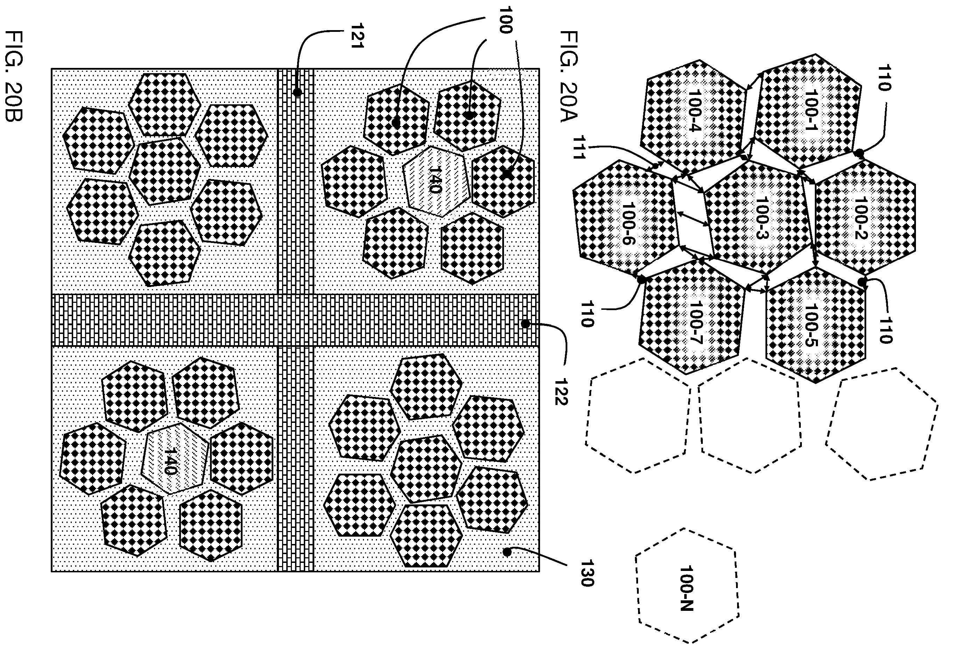

FIG. 20A, 20B, show examples of a solar panel pyramid arrangement that comprises a plurality of solar-panel pyramids 100-1, 100-2, ....,100-N. In the embodiment of FIG. 20A, mutually neighboring solar-panel pyramids are mechanically elastically coupled, here by flexible joints 110. Alternatively or additionally flexible joints 111may be provided at an other location, for example at each side at a central position of a respective neighboring side of neighboring pyramids.

Buffer elements (not shown) may be provided to avoid that neighboring solar-panel pyramids can directly touch each other. Alternatively, as shown in FIG. 20B, the solar-panel pyramids may be mounted to a web, which may be pre-tensioned. In the embodiment of FIG. 20B, also maintenance paths 121, 122 are provided that extend through the arrangement, to enable access of individual solar-panel pyramids. At some locations vacancies 140 are provide where the sea surface is exposed to allow sunlight to enter the water surface, and to provide for a contact with the atmosphere.

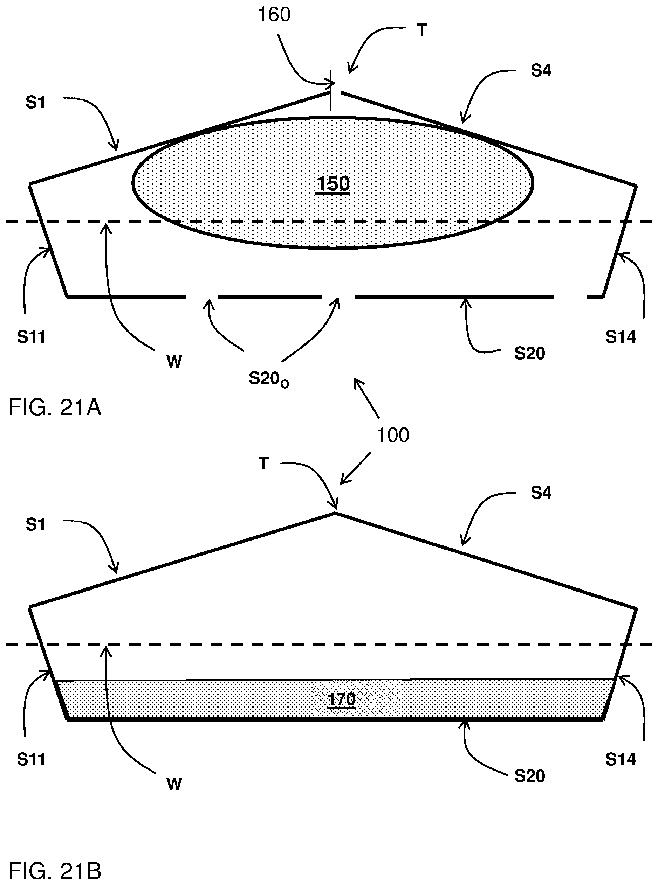

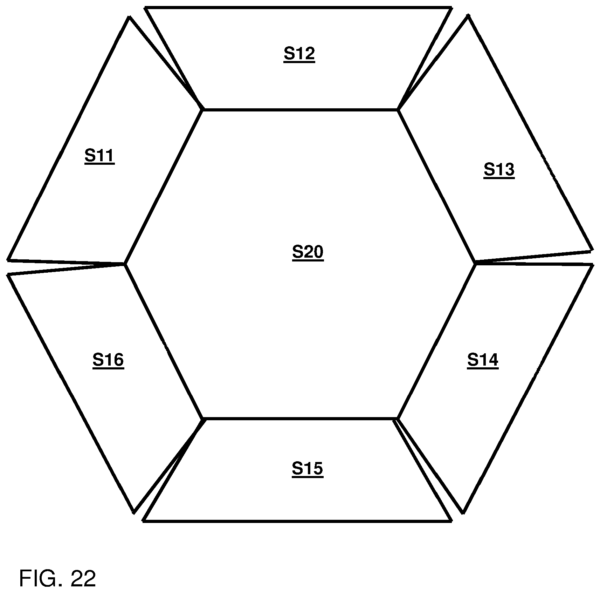

FIG. 21A, 21B schematically shows further embodiments of solar panel pyramids configured to float on a water surface W. In these embodiments, the solar panel pyramid 100 further comprises a truncated pyramid part, which is oriented in a direction opposite to that of the pyramid formed by the at least substantially triangular planar sections S1,..., S6. The truncated pyramid part comprises a plurality of trapezoid planar sections S11, S16 (See FIG. 22) and a polygonal planar bottom section S20. Each of the triangular planar sections S1, ...,S6 is connected at its edge opposite to the top T via a respective plastically deformed section to a respective one of the trapezoid planar sections S11,...,S16. For example S1 is connected to S11 and S4 is connected to S14. Furthermore, pairs of neighboring trapezoid planar sections S11,...,S16 are connected in a respective plastically deformed section to each other, and each trapezoid planar section S11,...,S16 is connected in a respective plastically deformed section at an edge facing away from the top to a respective edge of the polygonal planar bottom section S20.

In the embodiment of FIG. 21A, the solar panel pyramid 100 further comprises an air-bag 150 accommodated in its interior. Additionally, an air valve 160 is provided at a side which is in use configured to be above water level W, and openings S20_{O} are provided at a side which is in use configured to be below water level W. The openings may be sufficiently large to enable water to penetrate into the interior, but to prevent that crustacean can enter the interior, risking damaging of the airbag 150.

In the embodiment of FIG. 21B, the solar panel pyramid 100 defines a closed volume that is partly filled with air and partly filled with a ballast 170.

FIG. 22 shows a semi-finished component, with which in combination with the product shown in FIG. 19D a solar panel pyramid as shown in FIG. 21A or 21B can be manufactured. The semi-finished product shown in FIG. 22 comprises a polygonal planar bottom section S20 and trapezoid sections S11,..., S16 that connected at respective sides of the polygonal planar bottom section S20. The semi-finished product shown in FIG. 22 may be manufactured for example from a same planar material as that shown in FIG. 19A. As shown in FIG. 22, the trapezoid planar sections S11,...,S16 widen in a direction away from the polygonal planar section S20. The trapezoid planar sections S11,...,S16 are tilted inwards along their edge with the polygonal planar section S20, and each pair of neighboring trapezoid planar sections S11- S12; S12-S13; S13-S14; S14-S15; S15-S16 and S16-S11 are connected at in a respective thermoplastically deformed zone. In one example the neighboring edges are directly fused together, and in another embodiment the neighboring edges are fused through an intermediary strip of material. Finally, the remaining, most outward edges of the trapezoid planar sections are connected with a respective triangular planar section in in a respective thermoplastically deformed zone in the base plane of the solar panel pyramid. Likewise, this connection may be achieved by direct fusing or through an intermediary strip of material. In an embodiment, this final step of connecting the trapezoid planar sections with the triangular planar sections is performed at the location of use of the solar panel pyramid 100. This is advantageous in that the top parts can be stacked as well as the bottom parts during transport to the location of use.

For the purpose of clarity and a concise description, features are described herein as part of the same or separate embodiments, however, it will be appreciated that the scope of the invention may include embodiments having combinations of all or some of the features described. For example, while embodiments are shown for pre-formed panels and assemblies thereof, also panels with differently shaped and/or dimensioned mounting regions may be envisaged by those skilled in the art having the benefit of the present disclosure for achieving a similar function and result. The various elements of the embodiments as discussed and shown offer certain advantages, such as a low weight, improved ease of assembly, and ease of fabrication. Of course, it will be appreciated that any one of the above embodiments or processes may be combined with one or more other embodiments or processes to provide even further improvements in finding and matching designs and advantages. It is appreciated that this disclosure offers particular advantages to panel manufacturing and panel assemblies, e.g. mounting, and in general can be applied for any application wherein photovoltaic sandwich panels are used.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage.

## Claims

1. A pre-formed solar panel (1) to be mounted on a support plane (SP), the solar panel having in a direction from a first end (E1) to a second opposing end (E2) at least a first planar section (S1), a plastically deformed section (P) and a second planar section (S2), wherein the plastically deformed section maintains the first and the second planar section relative to each other at an enclosed angle (A1) in a range between 30° and 170°, and wherein an area of at least one of the planar sections is provided with a photovoltaic layer (3), wherein the sections are formed with a common back panel (2) comprising a honey comb panel (12) formed of a thermoplastically deformable polymer composition sandwiched between fiber reinforced front and back sheets (10,11) wherein between the opposing ends (E1, E2) the solar panel is formed as a stack comprising the photovoltaic layer (3) sandwiched between the back panel (2) and a protective front layer (4) .

2. The pre-formed solar panel (1) according to claim 1, wherein the sections have a length (LS1, LS2) between the plastically deformed section (P) and the respective opposing end of back panel (2) such that, when mounted, an enclosed angle (A2) between the at least one of the sections with a photovoltaic layer (3) and the support plane (SP) is in a range between 10° and 90°, and/or wherein the sections (S1,S2) have a length between the plastically deformed section (P) and their respective opposing end (E1, E2) such that, when mounted, the height of the pre-formed solar panel (1), defined as the distance between the support plane (SP) and the plastically deformed section (P), is in a range between 20 and 150 cm

3. The pre-formed solar panel (1) according to any of the preceding claims, further comprising a side-panel (6) at one or more of the sides of the pre-formed solar panel (1) to reduce a wind load on the pre-formed solar panel (1) when mounted on the support plane (SP).

4. The pre-formed solar panel (1) according to any of the preceding claims, wherein the panel comprises mounting regions (M1, M2) provided along an edge portion of the pre-formed solar panel (1) at a position along opposing ends of the back panel, wherein optionally one or more of the mounting regions (M1, M2) is provided with a means (13) for adhering the pre-formed solar panel (1) to the support plane (SP) , and/or wherein optionally one or more of the mounting regions is provided with cuts (14) (or slits) extending in a direction away from the edge portion of the pre-formed solar panel (1), and/or wherein optionally, the mounting regions are formed in a pattern arranged to, when mounted, interlock with a patterned mounting region of an adjacent pre-formed solar panel (1) or with a patterned mounting region of a mounting element.

5. An assembly (100) of a plurality of pre-formed solar panels (1) according to any one of claims 1-4 mounted on a carrier, wherein optionally the carrier (16) is a rail having at least one inwardly pointing edge and wherein a mounting section (Ma, Mb) of at least one pre-formed solar panel (1a, 1b) has a backwardly curved edge cooperating with said inwardly pointing edge, and/or wherein optionally said backwardly curved edge of the mounting section (Ma, Mb) is clamped against the inwardly pointing edge of the rail with a filling piece (16F) mounted in the rail, and/or wherein optionally adjacent pre-formed solar panels (1) are durably joined to form a continuous structure.

6. A solar panel pyramid, which comprises the preformed solar-panel according to claim 1, the preformed solar panel having at least three planar sections (S1, S2, ..., S6) including said at least a first planar section (S1) and a second planar section (S2), which are provided as at least substantially triangular planar sections having a common top (T), each planar section sharing a first plastically deformed section with a first neighboring planar section, and sharing a second plastically deformed section with a second neighboring planar section, wherein edges of said each planar sections opposite said top define a base-plane of the solar panel pyramid, said plastically deformed sections including a plastically deformed section between said first end (E1) and said second opposing end (E2).

7. The solar panel pyramid (100) according to claim 6, further comprising a truncated pyramid part, which is oriented in a direction opposite to that of the pyramid formed by the at least substantially triangular planar sections, the truncated pyramid part comprising a plurality of trapezoid planar sections and a polygonal planar bottom section, each of said triangular planar sections (S1, ...,S6) being connected at its edge opposite to said top via a respective plastically deformed section to a respective one of said trapezoid planar sections (S11,...,S16), pairs of neighboring trapezoid planar sections (S11,...,S16) being connected in a respective plastically deformed section to each other, and each trapezoid planar section (S11,...,S16) being connected in a respective plastically deformed section at an edge facing away from the top to a respective edge of the polygonal planar bottom section the solar panel pyramid (100) further optionally comprising:
- an air-bag (150) accommodated in its interior,
- an air valve (160) at a side which is in use configured to be above water level (W);
- openings (S20_{O}) at a side which is in use configured to be below water level (W), and/or optionally defining a closed volume that is partly filled with air and partly filled with a ballast (170).

8. The solar-panel pyramid according to one of the claims 6 or 7, further comprising a control unit (CTRLU) having a respective Maximum Power Point Tracker (MPPT1,...,MPPT6) for each photovoltaic layer associated with a respective substantially triangular planar section.

9. The solar-panel pyramid according to one of the claims 6 or 7, wherein the photovoltaic layer (3) is provided with one of back contact solar cells or thin film solar cells.

10. A solar-panel pyramid arrangement comprising a plurality of solar-panel pyramids according to one of the claims 6-9, wherein neighboring ones of said solar-panel pyramids are mechanically coupled in a flexible manner.

11. A method for manufacturing a pre-formed solar panel (1) according to claim 1, the method comprising:
- providing a thermoplastically deformable back panel (2)
- plastically deforming a section (P) of the back panel (2) to form at least a first and second planar sections (S1,S2) separated by the plastically deformed section (P), and wherein the plastically deformed section maintains the first and the second planar section relative to each other at an enclosed angle (A1) in a range between 30° and 170°.

12. A method according to claim 11, further comprising::
- providing a preformed solar panel (100AB) with at least three, at least substantially triangular planar sections (S1, S2,...,S6), each pair of mutually subsequent substantially triangular planar sections being coupled by a respective plastically deformed section (P12, P23, ..., P56), a first edge portion (e1) of a first one (S1) of said substantially triangular planar sections defining the first end (E1) and a second edge portion (e2) of a last one (S6) of said at least substantially triangular planar sections defining the second opposing end (E2),
- contacting, optionally via a strip of a thermoplastically deformable material, and heating the first and the second edge portion (e1, e2), and optionally the strip of a thermoplastically deformable material, for a time and temperature suitable to fuse the first one (S1) and the last one (S6) of said substantially triangular planar sections along a plastically deformed section (P) to form a solar panel pyramid (100).

13. The method according to claim 12, wherein the preformed solar panel (100AB) with at least three, at least substantially triangular planar sections, is provided from a first preformed solar panel (100A) and a second preformed solar panel (100B), which each have one or more at least substantially triangular planar sections, the total number of at least substantially triangular planar sections being equal to said at least three, the first preformed solar panel (100A) having said first edge portion (e1) as well as a first intermediate edge portion (e12), the second preformed solar panel (100B) having said second edge portion (e2), and further having a second intermediate edge-portion (e21),
- contacting, optionally via a strip of a thermoplastically deformable material, and heating the first and the second intermediate edge portion (e12, e21), and optionally the strip of a thermoplastically deformable material, for a time and temperature suitable to fuse the first and the second preformed solar panel (100A, 100B) to obtain the preformed solar panel (100AB) with at least three, at least substantially triangular planar sections.

14. The method according to claim 12 or 13, providing a further element comprising a polygonal planar section (S20), and at each side of said polygonal planar section a respective trapezoid planar section (S11,...,S16) that widens in a direction away from the polygonal planar section (S20), tilting the trapezoid planar sections (S11,...,S16) inwards along their edge with the polygonal planar section (S20), connecting each pair of neighboring trapezoid planar sections (S11,...,S16) in a respective thermoplastically deformed zone, and connecting a remaining edge of each trapezoid planar section with a respective triangular planar section in in a respective thermoplastically deformed zone in the bas plane of the solar panel pyramid.

15. The method according to claim 14, wherein said connecting a remaining edge of each trapezoid planar section is performed at the location of use of the solar panel pyramid (100).

## Patentansprüche

1. Vorgeformtes Solarpaneel (1) zur Montage auf einer Trägerebene (SP), wobei das Solarpaneel in einer Richtung von einem ersten Ende (E1) zu einem zweiten gegenüberliegenden Ende (E2) mindestens einen ersten planaren Abschnitt (S1), einen plastisch verformten Abschnitt (P) und einen zweiten planaren Abschnitt (S2) aufweist, wobei der plastisch verformte Abschnitt den ersten und den zweiten planaren Abschnitt relativ zueinander unter einem eingeschlossenen Winkel (A1) in einem Bereich zwischen 30° und 170° hält und wobei eine Fläche mindestens eines der planaren Abschnitte mit einer photovoltaischen Schicht (3) versehen ist, wobei die Abschnitte mit einem gemeinsamen Rückpaneel (2) ausgebildet sind, das ein Wabenpaneel (12) umfasst, das aus einer thermoplastisch verformbaren Polymerzusammensetzung gebildet ist, die zwischen faserverstärkten Vorder- und Rückseitenlagen (10,11) angeordnet ist, wobei das Solarpaneel zwischen den gegenüberliegenden Enden (E1, E2) als ein Stapel ausgebildet ist, der die zwischen dem Rückpaneel (2) und einer schützenden Frontschicht (4) angeordnete photovoltaische Schicht (3) umfasst.

2. Vorgeformtes Solarpaneel (1) nach Anspruch 1, wobei die Abschnitte zwischen dem plastisch verformten Abschnitt (P) und dem jeweiligen gegenüberliegenden Ende des Rückpaneels (2) eine derartige Länge (LS1, LS2) aufweisen, dass im montierten Zustand ein eingeschlossener Winkel (A2) zwischen dem mindestens einen der Abschnitte mit einer photovoltaischen Schicht (3) und der Trägerebene (SP) in einem Bereich zwischen 10° und 90° liegt, und/oder wobei die Abschnitte (S1,S2) zwischen dem plastisch verformten Abschnitt (P) und ihrem jeweiligen gegenüberliegenden Ende (E1, E2) eine derartige Länge aufweisen, dass im montierten Zustand die Höhe des vorgeformten Solarpaneels (1), definiert als der Abstand zwischen der Trägerebene (SP) und dem plastisch verformten Abschnitt (P), in einem Bereich zwischen 20 und 150 cm liegt.

3. Vorgeformtes Solarpaneel (1) nach einem der vorhergehenden Ansprüche, ferner umfassend ein Seitenpaneel (6) an einer oder mehreren der Seiten des vorgeformten Solarpaneels (1), um im auf der Trägerebene (SP) montierten Zustand eine Windlast auf das vorgeformte Solarpaneel (1) zu reduzieren.

4. Vorgeformtes Solarpaneel (1) nach einem der vorhergehenden Ansprüche, wobei das Paneel Montagebereiche (M1, M2) umfasst, die entlang eines Randabschnitts des vorgeformten Solarpaneels (1) an einer Position entlang gegenüberliegender Enden des Rückpaneels vorgesehen sind, wobei optional einer oder mehrere der Montagebereiche (M1, M2) mit einem Mittel (13) zum Anhaften des vorgeformten Solarpaneels (1) an der Trägerebene (SP) versehen sind und/oder wobei optional einer oder mehrere der Montagebereiche mit Schnitten (14) (oder Schlitzen) versehen sind, die sich in einer von dem Randabschnitt des vorgeformten Solarpaneels (1) wegführenden Richtung erstrecken, und/oder wobei optional die Montagebereiche in einem Muster ausgebildet sind, das dazu eingerichtet ist, im montierten Zustand mit einem gemusterten Montagebereich eines benachbarten vorgeformten Solarpaneels (1) oder mit einem gemusterten Montagebereich eines Montageelements ineinanderzugreifen.

5. Anordnung (100) aus einer Mehrzahl von vorgeformten Solarpaneelen (1) nach einem der Ansprüche 1-4, die auf einem Träger montiert sind, wobei optional der Träger (16) eine Schiene mit mindestens einem nach innen weisenden Rand ist und wobei ein Montageabschnitt (Ma, Mb) mindestens eines vorgeformten Solarpaneels (1a, 1b) einen nach hinten gekrümmten Rand aufweist, der mit dem nach innen weisenden Rand zusammenwirkt, und/oder wobei optional der nach hinten gekrümmte Rand des Montageabschnitts (Ma, Mb) mittels eines in der Schiene montierten Füllstücks (16F) gegen den nach innen weisenden Rand der Schiene geklemmt ist und/oder wobei optional benachbarte vorgeformte Solarpaneele (1) dauerhaft miteinander verbunden sind, um eine kontinuierliche Struktur zu bilden.

6. Solarpaneelpyramide, die das vorgeformte Solarpaneel nach Anspruch 1 umfasst, wobei das vorgeformte Solarpaneel mindestens drei planare Abschnitte (S1, S2, ..., S6) einschließlich des mindestens einen ersten planaren Abschnitts (S1) und eines zweiten planaren Abschnitts (S2) aufweist, die als mindestens im Wesentlichen dreieckige planare Abschnitte mit einer gemeinsamen Spitze (T) vorgesehen sind, wobei jeder planare Abschnitt einen ersten plastisch verformten Abschnitt mit einem ersten benachbarten planaren Abschnitt teilt und einen zweiten plastisch verformten Abschnitt mit einem zweiten benachbarten planaren Abschnitt teilt, wobei der Spitze gegenüberliegende Ränder jedes der planaren Abschnitte eine Basisebene der Solarpaneelpyramide definieren, wobei die plastisch verformten Abschnitte einen plastisch verformten Abschnitt zwischen dem ersten Ende (E1) und dem zweiten gegenüberliegenden Ende (E2) einschließen.

7. Solarpaneelpyramide (100) nach Anspruch 6, ferner umfassend einen Pyramidenstumpfteil, der in einer Richtung entgegengesetzt zu derjenigen der durch die mindestens im Wesentlichen dreieckigen planaren Abschnitte gebildeten Pyramide ausgerichtet ist, wobei der Pyramidenstumpfteil eine Mehrzahl von trapezförmigen planaren Abschnitten und einen polygonalen planaren Bodenabschnitt umfasst, wobei jeder der dreieckigen planaren Abschnitte (S1, ...,S6) an seinem der Spitze gegenüberliegenden Rand über einen jeweiligen plastisch verformten Abschnitt mit einem jeweiligen der trapezförmigen planaren Abschnitte (S11,...,S16) verbunden ist, wobei Paare benachbarter trapezförmiger planarer Abschnitte (S11,...,S16) in einem jeweiligen plastisch verformten Abschnitt miteinander verbunden sind und jeder trapezförmige planare Abschnitt (S11,...,S16) in einem jeweiligen plastisch verformten Abschnitt an einem von der Spitze abgewandten Rand mit einem jeweiligen Rand des polygonalen planaren Bodenabschnitts verbunden ist, wobei die Solarpaneelpyramide (100) ferner optional Folgendes umfasst:
- einen in ihrem Inneren aufgenommenen Luftsack (150),
- ein Luftventil (160) an einer Seite, die im Gebrauch dazu eingerichtet ist, oberhalb des Wasserspiegels (W) zu liegen;
- Öffnungen (S20_{O}) an einer Seite, die im Gebrauch dazu eingerichtet ist, unterhalb des Wasserspiegels (W) zu liegen, und/oder optional ein geschlossenes Volumen definiert, das teilweise mit Luft und teilweise mit einem Ballast (170) gefüllt ist.

8. Solarpaneelpyramide nach einem der Ansprüche 6 oder 7, ferner umfassend eine Steuereinheit (CTRLU), die für jede einer jeweiligen im Wesentlichen dreieckigen planaren Sektion zugeordnete photovoltaische Schicht einen jeweiligen Maximum-Power-Point-Tracker (MPPT1,...,MPPT6) aufweist.

9. Solarpaneelpyramide nach einem der Ansprüche 6 oder 7, wobei die photovoltaische Schicht (3) mit Rückkontakt-Solarzellen oder Dünnschicht-Solarzellen versehen ist.

10. Solarpaneelpyramidenanordnung, umfassend eine Mehrzahl von Solarpaneelpyramiden nach einem der Ansprüche 6-9, wobei benachbarte der Solarpaneelpyramiden auf flexible Weise mechanisch gekoppelt sind.

11. Verfahren zur Herstellung eines vorgeformten Solarpaneels (1) nach Anspruch 1, wobei das Verfahren Folgendes umfasst:
- Bereitstellen eines thermoplastisch verformbaren Rückpaneels (2)
- plastisches Verformen eines Abschnitts (P) des Rückpaneels (2), um mindestens einen ersten und einen zweiten planaren Abschnitt (S1,S2) zu bilden, die durch den plastisch verformten Abschnitt (P) getrennt sind, und wobei der plastisch verformte Abschnitt den ersten und den zweiten planaren Abschnitt relativ zueinander unter einem eingeschlossenen Winkel (A1) in einem Bereich zwischen 30° und 170° hält.

12. Verfahren nach Anspruch 11, ferner umfassend::
- Bereitstellen eines vorgeformten Solarpaneels (100AB) mit mindestens drei, mindestens im Wesentlichen dreieckigen planaren Abschnitten (S1, S2,...,S6), wobei jedes Paar aufeinanderfolgender im Wesentlichen dreieckiger planarer Abschnitte durch einen jeweiligen plastisch verformten Abschnitt (P12, P23, ..., P56) gekoppelt ist, wobei ein erster Randabschnitt (e1) eines ersten (S1) der im Wesentlichen dreieckigen planaren Abschnitte das erste Ende (E1) definiert und ein zweiter Randabschnitt (e2) eines letzten (S6) der mindestens im Wesentlichen dreieckigen planaren Abschnitte das zweite gegenüberliegende Ende (E2) definiert,
- Inkontaktbringen, optional über einen Streifen aus einem thermoplastisch verformbaren Material, und Erwärmen des ersten und des zweiten Randabschnitts (e1, e2) und optional des Streifens aus einem thermoplastisch verformbaren Material für eine Zeit und auf eine Temperatur, die geeignet sind, den ersten (S1) und den letzten (S6) der im Wesentlichen dreieckigen planaren Abschnitte entlang eines plastisch verformten Abschnitts (P) zu verschmelzen, um eine Solarpaneelpyramide (100) zu bilden.

13. Verfahren nach Anspruch 12, wobei das vorgeformte Solarpaneel (100AB) mit mindestens drei, mindestens im Wesentlichen dreieckigen planaren Abschnitten aus einem ersten vorgeformten Solarpaneel (100A) und einem zweiten vorgeformten Solarpaneel (100B) bereitgestellt wird, die jeweils einen oder mehrere mindestens im Wesentlichen dreieckige planare Abschnitte aufweisen, wobei die Gesamtzahl der mindestens im Wesentlichen dreieckigen planaren Abschnitte gleich den mindestens drei ist, wobei das erste vorgeformte Solarpaneel (100A) den ersten Randabschnitt (e1) sowie einen ersten Zwischenrandabschnitt (e12) aufweist und das zweite vorgeformte Solarpaneel (100B) den zweiten Randabschnitt (e2) aufweist und ferner einen zweiten Zwischenrandabschnitt (e21) aufweist,
- Inkontaktbringen, optional über einen Streifen aus einem thermoplastisch verformbaren Material, und Erwärmen des ersten und des zweiten Zwischenrandabschnitts (e12, e21) und optional des Streifens aus einem thermoplastisch verformbaren Material für eine Zeit und auf eine Temperatur, die geeignet sind, das erste und das zweite vorgeformte Solarpaneel (100A, 100B) zu verschmelzen, um das vorgeformte Solarpaneel (100AB) mit mindestens drei, mindestens im Wesentlichen dreieckigen planaren Abschnitten zu erhalten.

14. Verfahren nach Anspruch 12 oder 13, umfassend das Bereitstellen eines weiteren Elements, das einen polygonalen planaren Abschnitt (S20) und an jeder Seite des polygonalen planaren Abschnitts einen jeweiligen trapezförmigen planaren Abschnitt (S11,...,S16) umfasst, der sich in einer von dem polygonalen planaren Abschnitt (S20) wegführenden Richtung verbreitert, das Einwärtsneigen der trapezförmigen planaren Abschnitte (S11,...,S16) entlang ihres Randes mit dem polygonalen planaren Abschnitt (S20), das Verbinden jedes Paars benachbarter trapezförmiger planarer Abschnitte (S11,...,S16) in einer jeweiligen thermoplastisch verformten Zone und das Verbinden eines verbleibenden Randes jedes trapezförmigen planaren Abschnitts mit einem jeweiligen dreieckigen planaren Abschnitt in einer jeweiligen thermoplastisch verformten Zone in der Basisebene der Solarpaneelpyramide.

15. Verfahren nach Anspruch 14, wobei das Verbinden eines verbleibenden Randes jedes trapezförmigen planaren Abschnitts am Einsatzort der Solarpaneelpyramide (100) durchgeführt wird.

## Revendications

1. Panneau solaire préformé (1) destiné à être monté sur un plan de support (SP), le panneau solaire ayant, dans une direction allant d'une première extrémité (E1) à une deuxième extrémité (E2) opposée, au moins une première section plane (S1), une section plastiquement déformée (P) et une deuxième section plane (S2), dans lequel la section plastiquement déformée maintient la première et la deuxième section plane l'une par rapport à l'autre selon un angle fermé (A1) dans une plage comprise entre 30° et 170°, et dans lequel une zone d'au moins l'une des sections planes est pourvue d'une couche photovoltaïque (3), dans lequel les sections sont formées avec un panneau arrière (2) commun comprenant un panneau en nid d'abeilles (12) formé avec une composition polymère déformable par voie thermoplastique prise en sandwich entre des feuilles avant et arrière renforcées en fibres (10, 11), dans lequel, entre les extrémités (E1, E2) opposées, le panneau solaire est formé comme un empilement comprenant la couche photovoltaïque (3) prise en sandwich entre le panneau arrière (2) et une couche de protection avant (4).

2. Panneau solaire préformé (1) selon la revendication 1, dans lequel les sections ont une longueur (LS1, LS2) entre la section plastiquement déformée (P) et l'extrémité opposée respective du panneau arrière (2) de sorte que, lorsqu'elles sont montées, un angle fermé (A2) entre la au moins une des sections avec une couche photovoltaïque (3) et le plan de support (SP) est dans une plage comprise entre 10° et 90°, et/ou dans lequel les sections (S1, S2) ont une longueur entre la section plastiquement déformée (P) et leur extrémité (E1, E2) opposée respective de sorte que, lorsqu'il est monté, la hauteur du panneau solaire préformé (1), définie comme étant la distance entre le plan de support (SP) et la section plastiquement déformée (P), est dans une plage comprise entre 20 et 150 cm.

3. Panneau solaire préformé (1) selon l'une quelconque des revendications précédentes, comprenant en outre un panneau latéral (6) au niveau d'un ou de plusieurs côtés du panneau solaire préformé (1) afin de réduire un effort dû au vent sur le panneau solaire préformé (1), lorsqu'il est monté sur le plan de support (SP).

4. Panneau solaire préformé (1) selon l'une quelconque des revendications précédentes, dans lequel le panneau comprend des régions de montage (M1, M2) prévues le long d'une partie de bord du panneau solaire préformé (1) dans une position le long des extrémités opposées du panneau arrière, dans lequel, facultativement, une ou plusieurs des régions de montage (M1, M2) est (sont) pourvue(s) de moyens (13) pour faire adhérer le panneau solaire préformé (1) au plan de support (SP), et/ou dans lequel facultativement, une ou plusieurs des régions de montage est (sont) pourvue(s) de coupes (14) (ou de fentes) s'étendant dans une direction à l'opposé de la partie de bord du panneau solaire préformé (1), et/ou dans lequel facultativement, les régions de montage sont formées selon un motif agencé pour, lorsqu'elles sont montées, s'emboîter avec une région de montage à motif d'un panneau solaire préformé (1) adjacent ou avec une région de montage à motif d'un élément de montage.

5. Ensemble (100) d'une pluralité de panneau solaire préformés (1) selon l'une quelconque des revendications 1 à 4, montés sur un support, dans lequel facultativement le support (16) est un rail ayant au moins un bord orienté vers l'intérieur et dans lequel une section de montage (Ma, Mb) d'au moins un panneau solaire préformé (1a, 1b) a un bord courbé vers l'arrière coopérant avec ledit bord orienté vers l'intérieur, et/ou dans lequel facultativement ledit bord courbé vers l'arrière de la section de montage (Ma, Mb) est serré contre le bord orienté vers l'intérieur du rail avec une pièce de remplissage (16F) montée dans le rail, et/ou dans lequel facultativement, les panneau solaire préformés (1) adjacents sont assemblés de manière durable afin de former une structure continue.

6. Pyramide de panneau solaire, qui comprend le panneau solaire préformé selon la revendication 1, le panneau solaire préformé ayant au moins trois sections planes (S1, S2, ..., S6) comprenant ladite au moins une section plane (S1) et une deuxième section plane (S2), qui sont prévues comme étant des sections planes au moins sensiblement triangulaires ayant un sommet commun (T), chaque section plane partageant une première section plastiquement déformée avec une premier section plane voisine, et partageant une deuxième section plastiquement déformée avec une deuxième section plane voisine, dans laquelle les bords de chacune desdites sections planes opposées audit sommet définissent un plan de base de la pyramide de panneau solaire, lesdites sections plastiquement déformées comprenant une section plastiquement déformée entre ladite première extrémité (E1) et ladite deuxième extrémité (E2) opposée.

7. Pyramide de panneau solaire (100) selon la revendication 6, comprenant en outre une partie de pyramide tronquée, qui est orientée dans une direction opposée à celle de la pyramide formée par les sections planes au moins sensiblement triangulaires, la partie de pyramide tronquée comprenant une pluralité de sections planes trapézoïdales et une section inférieure plane polygonale, chacune desdites sections planes triangulaires (S1, ..., S6) étant raccordée au niveau de son bord opposé audit sommet, via une section plastiquement déformée respective, à une section respective desdites sections planes trapézoïdales (S11, ..., S16), les paires de sections planes trapézoïdales (S11, ..., S16) voisines étant raccordées entre elles au niveau d'une section plastiquement déformée respective, et chaque section plane trapézoïdale (S11, ..., S16) étant raccordée au niveau d'une section plastiquement déformée, au niveau d'un bord orienté à l'opposé du sommet, à un bord respectif de la section inférieure plane polygonale, la pyramide de panneau solaire (100) comprenant en outre facultativement :
un coussin gonflable (150) logé dans son intérieur ;
une valve d'air (160) au niveau d'un côté qui est, à l'usage, configuré pour être au-dessus du niveau de l'eau (W) ;
des ouvertures (S20_{O}) au niveau d'un côté qui est, à l'usage, configuré pour être au-dessous du niveau de l'eau (W) et/ou définissant facultativement un volume fermé qui est partiellement rempli avec de l'air et partiellement rempli avec un lest (170).

8. Pyramide de panneau solaire (100) selon l'une des revendications 6 ou 7, comprenant en outre une unité de commande (CTRLU) ayant un suiveur du point de puissance maximale (MPPT1, MPPT6) respectif pour chaque couche photovoltaïque associée à une section plane sensiblement triangulaire respective.

9. Pyramide de panneau solaire selon l'une des revendications 6 ou 7, dans laquelle la couche photovoltaïque (3) est prévue avec l'une parmi les cellules solaires à contact arrière ou les cellules solaires à film fin.

10. Agencement de pyramide de panneau solaire comprenant une pluralité de pyramides de panneau solaire selon l'une des revendications 6 à 9, dans lequel les pyramides voisines desdites pyramides de panneau solaire sont mécaniquement couplées d'une manière flexible.

11. Procédé pour fabriquer un panneau solaire préformé (1) selon la revendication 1, le procédé comprenant les faits de :
prévoir un panneau arrière déformable par voie thermoplastique (2),
déformer plastiquement une section (P) du panneau arrière (2) afin de former au moins une première et une deuxième section plane (S1, S2) séparées par la section plastiquement déformée (P), et dans lequel la section plastiquement déformée maintient la première et la deuxième section plane l'une par rapport à l'autre à un angle fermé (A1) dans une plage comprise entre 30° et 170°.

12. Procédé selon la revendication 11, comprenant en outre les faits de :
prévoir un panneau solaire préformé (100AB) avec au moins trois sections planes au moins sensiblement triangulaires (S1, S2, ..., S6), chaque paire de sections planes sensiblement triangulaires mutuellement consécutives étant couplée par une section plastiquement déformée (P12, P23, ..., P56) respective, une première partie de bord (e1) d'une première section (S1) desdites sections planes sensiblement triangulaires définissant la première extrémité (E1) et une deuxième partie de bord (e2) d'une dernière section (S6) desdites sections planes au moins sensiblement triangulaires définissant la deuxième extrémité (E2) opposée,
mettre en contact, éventuellement, via une bande d'un matériau déformable par voie thermoplastique, et chauffer la première et la deuxième partie de bord (e1, e2) et facultativement la bande d'un matériau déformable par voie thermoplastique, pour une durée et une température appropriées pour faire fondre la première (S1) et la dernière (S6) desdites sections planes sensiblement triangulaires le long d'une section plastiquement déformée (P) afin de former une pyramide de panneau solaire (100).

13. Procédé selon la revendication 12, dans lequel le panneau solaire préformé (100AB) avec au moins trois sections planes au moins sensiblement triangulaires, est prévu à partir d'un premier panneau solaire préformé (100A) et d'un deuxième panneau solaire préformé (100B), qui ont chacun une ou plusieurs sections planes au moins sensiblement triangulaires, le nombre total de sections planes au moins sensiblement triangulaires étant égal audites au moins trois, le premier panneau solaire préformé (100A) ayant ladite première partie de bord (e1) ainsi qu'une première partie de bord intermédiaire (e12), le deuxième panneau solaire préformé (100B) ayant ladite deuxième partie de bord (e2) et en outre ayant une deuxième partie de bord intermédiaire (e21),
mettre en contact, facultativement via une bande d'un matériau déformable par voie thermoplastique, et chauffer la première et la deuxième partie de bord intermédiaire (e12, e21) et facultativement la bande d'un matériau déformable par voie thermoplastique, pour une durée et une température appropriées pour faire fondre le premier et le deuxième panneau solaire préformé (100A, 100B) afin d'obtenir le panneau solaire préformé (100AB) avec au moins trois sections planes au moins sensiblement triangulaires.

14. Procédé selon la revendication 12 ou 13, comprenant les faits de prévoir un autre élément comprenant une section plane polygonale (S20) et au niveau de chaque côté de ladite section plane polygonale, une section plane trapézoïdale (S11, ..., S16) respective qui s'élargit dans une direction à l'opposé de la section plane polygonale (S20), incliner les sections planes trapézoïdales (S11, ..., S16) vers l'intérieur le long de leur bord avec la section plane polygonale (S20), raccorder chaque paire de sections planes trapézoïdales (S11, ..., S16) voisines dans une zone déformée par voie thermoplastique respective, et raccorder un bord résiduel de chaque section plane trapézoïdale avec une section plane triangulaire respective dans une zone déformée par voie thermoplastique respective dans le plan de base de la pyramide de panneau solaire.

15. Procédé selon la revendication 14, dans lequel ledit fait de raccorder un bord résiduel de chaque section plane trapézoïdale est réalisé à l'emplacement d'utilisation de la pyramide de panneau solaire (100).
